# EUROPEAN PATENT SPECIFICATION

(11) **EP 1 764 618 B1**
(45) Date of publication and mention of the grant of the patent: **22.05.2013**
(21) Application number: 06014060.5
(22) Date of filing: 06.07.2006
(51) Int. Cl.: G01R 22/06

(54) **Rack-mounted power meter having removable metering options module**
In einem Baugruppenträger montierter Leistungsmesser mit abnehmbarem Messoptionsmodul
Compteur d'électricité monté en baie ayant un module de comptage optionnel

(30) Priority: 16.09.2005 US 717688 P; 31.05.2006 US 444031
(43) Date of publication of application: 21.03.2007
(73) Proprietor: Power Measurement Ltd, British Columbia V8M 2A5 (CA)
(72) Inventor: Loewen, Daniel N., Sidney BC, V8L 2E5 (CA); Bandsmer, Michael D., Victoria BC, V8Z 2B3 (CA); Harding, Stewart J., Victoria BC, V8P 1M7 (CA); Przydatek, Piotr B., Victoria BC, V8X 1E5 (CA); Hancock, Martin A., Victoria BC, V8X 3S8 (CA)
(74) Representative: Grünecker, Kinkeldey, Stockmair & Schwanhäusser

(56) References cited:
- EP-A1- 0 511 482
- EP-A1- 1 004 028
- EP-A1- 1 460 435
- EP-A2- 0 913 696
- DE-A1- 3 615 402
- GB-A- 2 300 724
- GB-A- 2 334 338
- US-A- 6 016 432

## Description

### BACKGROUND

### 1. Field of the invention

The present invention relates to power metering, and more particularly to a rack-mounted revenue and power quality power meter with an options module that is removable to provide an adaptable modular meter.

### 2. Background and Relevant Art

Power metering technology is evolving towards multi-functional metering systems. Power meters provide feedback for voltage, current, and power in one or more power lines. The meter also may be configured to provide control functions for a load connected to a power line. Commonly, a meter may be configured for revenue metering, including circuitry and features that allow monitoring of energy usage for the purposes of determining energy costs. Alternatively, a meter may be configured to provide power quality metering, including precisely calibrated circuitry to accurately determine dynamics of one or more power lines. Power meters may include communications features that allow bidirectional communication with the meter. An integrated communications circuit allows the meter to communicate with other devices such as a computer, other meters, control panels and the like. The communications feature may communicate over an open network using a communication protocol.

Certain classes of power meters are physically designed to be installed, or mounted, in a rack. The enclosure of a rack-mounted meter has predetermined maximum external dimensions to allow the meter to be inserted in a standard rack. The rack-mounted design also has electrical connections having a standardized configuration that allows the meter to be connected to standard connections on a rack. The arrangement of the electrical connections is fixed so that the rack-mounted meter may be used in standard configuration racks.

Power metering needs often differ from installation to installation. The meter may need a customized configuration to be integrated within an existing power distribution system. Existing rack-mounted power meters needing such a customized configuration may have additional hardware installed under a front cover plate of the meter, or in some other location internal to the meter housing. Such an installation not only requires the meter be physically dismantled, but also requires removal of utility or verification seals. Removal of such seals requires that the meter be sent out to a verification shop, or otherwise taken out of service until the meter can be re-verified and/or inspected, and new seals applied by the appropriate third party.

GB 2 334 338 (A) relates to a tamper detection in an electro-mechanical electricity consumption meter. Thereby, a module, which includes an electrical circuit means for detecting tamper to a meter, is fitted outside the sealed housing of the meter and enclosed by a sealable terminal cover. In order to detect tamper, the module that has the electrical circuit means further comprises an optical pickup for detecting rotation of a rotatable component through the sealed housing and the electrical circuit means being able to detect reverse rotation of the rotatable component indicating that the meter is being tampered with.

US 6,016,432 relates to a utility meter, which is used for registering the magnitude of electricity, gas, or the like. Further, a modular unit may be placed within a mounting slot of the utility meter. The document also shows that an audio system device may comprise a mounting slot for receipt of a module which may have a format such as, for instance, a PCMCIA card.

EP 0 511 482 A1 relates to a simple and inexpensive method of providing electricity meters with an external module and a device for carrying out this method.

EP 0 913 696 A2 provides an apparatus for metering of electric energy, which comprises a box-like case consisting of a bottom part and a cover part. The box contains various metering, control and equivalent modules necessary in a meter. The box of the meter also contains a compartment, into which various auxiliary function cards can be installed, such as receivers of network commands, communication means necessary for remote reading, and equivalent.

### BRIEF SUMMARY OF THE INVENTION

By way of introduction only, a rack-mounted power meter includes a removable, or replaceable, externally mounted metering options module. The rack-mounted power meter and the metering options module may be mounted in a bay of an equipment rack. The architecture of the rack-mounted power meter may be achieved by one or more apparatuses, devices, systems, methods, and/or processes.

The rack-mounted power meter is an adaptable power meter that may be modified and/or updated to meet current and future needs without requiring disassembly of the enclosure of the power meter, or disturbance of tamper-proof seals included on the power meter. A removable, metering options module may be mounted within a slot, cutout or shoulder of a meter housing of the power meter. The metering options module may be externally affixed to the rack-mounted power meter without exceeding the standard maximum external dimensions for a rack-mounted meter. Once mounted, the metering options module may be interfaced with, and enhance/change the functionality of metering circuitry included in the meter.

The metering options module includes circuitry that provides various additional features and functionality to change, enhance or upgrade the functionality of the meter. The metering options module is self-enclosed and may be sealed with a tamper-proof seal that is independent of the power meter. The metering options module may be coupled with the power meter to provide the additional functionality. The metering options module may provide functions not presently provided by the metering circuitry present within the meter. The metering options module may provide functionality that may add to, augment, supplement or substitute for an existing metering circuitry function, whether that function is communications, metering, monitoring, control or the like. The metering options module also may provide alternate or new modes to monitor, measure, or calculate electrical parameters. The metering options module is removable without substantially affecting the essential functions of the power meter. In addition, the metering options module may be installed and removed without disturbing a tamper proof seal, such as a calibration seal included on the power meter. The metering options module may have a separate housing that meets the standard meter enclosure requirements for mounting in an equipment rack assembly.

The foregoing summary is provided only by way of introduction. The features and advantages of the rack-mounted power meter having a removable metering options module may be realized and obtained by means of the instrumentalities and combinations particularly pointed out in the claims. Nothing in this section should be taken as a limitation on the claims, which define the scope of the invention. Additional features and advantages of the present invention will be set forth in the description that follows, and in part will be obvious from the description, or may be learned by practice of the present invention.

### BRIEF DESCRIPTION OF THE DRAWINGS

Figure 1 is a perspective front view of an example rack-mounted power meter that includes an external removable metering options module.

Figure 2 is a perspective front view of an example rack-mounted power meter of Figure 1 without an external removable metering options module mounted thereon.

Figure 3 is a perspective front view of an example rack-mounted power meter of Figure 1 that includes an external removable options module illustrated with a cover in an open position.

Figure 4 is a perspective rear view of the rack-mounted power meter of Figure 1 and an external removable metering options module.

Figure 5 is a perspective rear view of the rack-mounted power meter of Figure 1 without an external removable metering options module mounted thereon.

Figure 6 is a perspective rear view of an example rack-mounted power meter of Figure 1 illustrated with a cover in an open position that also includes an external removable metering options module.

Figure 7 is a front view of the rack-mounted power meter of Figure 1.

Figure 8 is a front view of the rack-mounted power meter of Figure 1 with a cover in an open position.

Figure 9 is a front view of another example of the rack-mounted power meter of Figure 1.

Figure 10 is a perspective front view of the rack mounted power meter of Figure 9, and a removable metering options module.

Figure 11 is a front view of the rack mounted power meter of Figure 9, with a removable metering options module mounted thereon.

Figure 12 is a rear view of the rack-mounted power meter of Figure 1 that includes an external removable metering options module.

Figure 13 is a rear view of the rack-mounted power meter of Figure 1 without an external removable metering options module mounted thereon.

Figure 14 is a perspective partially cutaway view of the rack-mounted power meter of Figure 1 illustrating an example of an internal connection for the rack-mounted meter of Figure 1.

Figure 15 is a perspective rear view of an example of a metering options module for the rack-mounted power meter of Figure 1.

Figure 16 is a rear view of an example of a metering options module for the rack-mounted power meter of Figure 1.

Figure 17 is a perspective front view of an example of a metering options module for the rack-mounted power meter of Figure 1.

Figure 18 is a front view of an example of a metering options module for the rack-mounted power meter of Figure 1.

Figure 19 is a block diagram of an example of a power meter and a removable metering options module of Figures 1-18.

Figure 20 is a block diagram of an example of an input/output module that may be included in the metering options module.

Figure 21 is a block diagram of an example of a communications module that may be included in the metering options module.

Figure 22 is a block diagram of an example of an access key module that may be included in the metering options module.

Figure 23 is a perspective top view of an example of the rack-mounted power meter of Figures 1-8 that includes an external removable metering options module, and is mounted in an equipment rack.

Figure 24 is a perspective front view of an example of the rack-mounted power meter of Figures 1-8 that includes an external removable metering options module, and is mounted in an equipment rack.

Figure 25 is a perspective rear view of an example of the rack-mounted power meter of Figures 1-8 that includes an external removable metering options module, and is mounted in an equipment rack.

### DETAILED DESCRIPTION OF THE EMBODIMENTS

A rack-mounted power meter having an externally mounted metering options module will now be described with reference to the accompanying drawings. In each of the following figures, components, features and integral parts that correspond to one another each have the same reference number. The drawings of the figures are not true to scale.

A rack-mounted power meter having an externally-mounted removable metering options module may be embodied in many different forms, formats, and designs, and should not be construed as limited to the examples set forth herein. The architecture for the rack-mounted power meter includes apparatuses, distributed networks, methods, processes, data processing systems, and software and firmware device. Features of the rack-mounted power meter having a removable external metering options module may be embodied as electronic components instructions, software, and/or firmware utilizing a computer program product on a computer-readable storage medium, such as memory, solid state memory, hard disks, CD-ROMs, optical storage devices, or magnetic storage devices.

Herein, the phrase "coupled with" or "coupled to" is defined to mean directly connected to or indirectly connected through one or more intermediate components. Such intermediate components may include both hardware and software based components. Further, to clarify the use in the pending claims and to hereby provide notice to the public, the phrases "at least one of <A>, <B>, ... and <N>" or "at least one of <A>, <B>,...<N> or combinations thereof" are defined by the Applicant in the broadest sense, superseding any other implied definitions herebefore or hereinafter unless expressly asserted by the Applicant to the contrary, to mean one or more elements selected from the group comprising A, B,... and N, that is to say, any combination of one or more elements A, B, ... or N including any one element alone or in combination with one or more of the other elements which may include, in combination, additional elements not listed.

The rack-mounted power meter having an externally-mounted removable metering options module (referred herein as the rack-mounted meter) may be designed to meet requirements of national and international standards setting bodies, such as International Electrotechnical Commission ("IEC"), while providing a meter that provides a rack mount form factor. The described examples relate to an apparatus for measuring power parameters on a conductor, such as a power line. Further, the described examples relate to a mechanical and electrical design and system that monitors power parameters on low, medium and high voltage conductors.

An example power meter may include metering circuitry comprising at least one processor capable of executing instructions stored in a memory of the power meter to direct the receipt and processing of signal(s) representative of power parameters. The metering circuitry may also include hardware, firmware and/or software based signal processing, filtering, and any other functionality related to monitoring and processing power parameters related to power quality and/or revenue metering. A global positioning system ("GPS"), and/or time-synchronization capabilities, that improve the measuring accuracy of the device and/or provide additional geo-location based capabilities may also be included in the metering circuitry of the power meter. Metering circuitry of example power meters may also include communications ports, antennas, either planar, GPS or both, facilitating ease of communication.

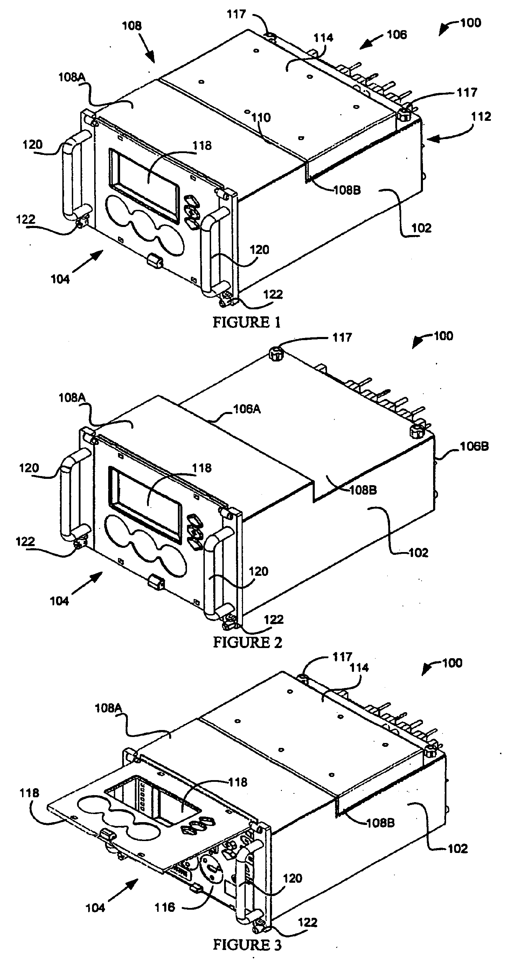

Figures 1-3 illustrate a perspective view of an example rack-mounted meter 100. The rack-mounted meter 100 may be inserted and mounted to an equipment rack assembly (not shown). The equipment rack assembly may provide an electrical connector having an input/output (I/O) interface and operating power for the meter 100. The rack-mounted meter 100 may be designed with a form factor having maximum external dimensions, such as dimensions that allow the rack-mounted meter to be used as a 48.3 centimeter equipment rack mounted meter. The rack-mounted meter 100 may be calibrated, and its meter housing may be sealed before being installed in a bay of an equipment rack assembly. The dimensions of the meter 100 are implementation dependent and may vary depending upon the type of equipment rack and standard dimensions supported therein.

Meter 100 may be sealed by including one or more tamper proof seals on/in/around the meter 100. The seal(s) may be external or internal to meter 100. The seal(s) may be attached during manufacture, during installation, or following installation. A tamper-proof seal is a physical device or mechanism that provides an indication when the seal(s) has been tampered with, or disturbed. The seal(s) may be made of various materials, and come in various designs, such as an adhesive strip design, a wire design, a lock design, a glass vial design, a plastic tie design, an electrical fuse design, a gravitational design and/or an inertial/shock detector design. For example, when the seal is a plastic tie, the seal may generally include a tab with a unique identifier, and a locking mechanism that cannot easily be opened without breaking or otherwise visibly altering the locking mechanism.

A tamper-proof seal can be applied to various parts of the meter 100 to detect tampering. In addition, a seal can be applied to structure surrounding the meter 100 to indicate removal and/or relocation of the meter 100 with respect to the surrounding structure. Example seal applications include application to an access door or cover included on the meter 100, application to a reset or other control button included on the meter 100, application to the casing of the meter 100, application to input/output points, and/or application to an external enclosure around at least a portion of the meter 100.

The meter 100 may have multiple tamper-proof seals that protect different parts of the device. Types of tamper-proof seals that may be used include seals used as revenue/verification seals, utility seals, or metering point identification seals. A revenue/verification seal may be controlled by a third party and verifies the accuracy of the meter. In the event a revenue verification seal is disturbed or broken, the meter 100 may need to be returned to the third party for re-verification and re-sealing prior to being further used in revenue calculations. A utility seal may be controlled by a user of the meter 100, such as an electrician at a utility, to guard against tampering. A metering point identification seal is a seal that may be used to uniquely identify the meter 100 and keep track of the location of the meter within a facility or system.

The rack-mounted meter 100 may integrate both power revenue metering and power quality class metering within an external form factor that may be rack-mounted in a bay. For example, the rack-mounted meter 100 may provide power quality analysis that meets Class A requirements of the IEC 61000-4-30 metering standard. The rack-mounted meter 100 may also be a revenue device that meets the requirements of IEC 62053-22. Accordingly, the rack-mounted meter 100 may provide power quality detection, monitoring, reporting, recording, analysis and communication along with revenue accuracy measurement and reporting. The rack-mounted meter 100 may integrate the features of power quality monitoring and revenue metering in a single power meter having a meter housing meeting the form factor requirements for installation and mounting in a bay of an equipment rack assembly. Examples of a power quality meter integrated with a revenue meter are described in US Patent 6,615,147, for a REVENUE METER WITH POWER QUALITY FEATURES, issued on September 2, 2003, and US Patent 6,792,364, for a REVENUE METER WITH POWER QUALITY FEATURES, issued on September 14, 2004, both of which are incorporated by reference in their entirety herein.

m one example, the rack-mounted meter 100 is configured to meet the IEC 61053-22 standard that also provides power quality analysis to the IEC 61000-4-30 standard class A. The meter 100 may be configured to meter single-phase or multi-phase power systems and loads, or combinations thereof. The meter 100 may be coupled with one or more conductors. The conductors may be power cables, high tension lines, bus duct, bus bar, substation terminals, generator terminals, circuit breaker terminals, and/or any other mechanism, device, or materials capable of conducting current and voltage. The conductor may be part of a two-wire, three-wire, and/or four-wire power system. The meter 100 may provide measurement of voltage and current to determine active, reactive, and/or apparent energy over a range of frequencies, or combinations thereof. In addition, the meter 100 may provide power quality measurement and processing of power parameters such as voltage and current harmonics, voltage and current inter-harmonics, voltage and current anomalies, such as sag/swell(s) or transient(s), and/or any other power quality related data and analysis.

The rack mounted meter 100 includes a meter housing 102. The meter housing 102 may have an external form factor, or frame structure, that is dimensioned to allow rack-mounting of the meter 100 in a bay of an equipment rack. Thus, an outer envelope of the meter housing 102 may be formed to fit within at least one bay of an equipment rack. The meter housing 102 may include at least six sides, and may be generally characterized by width, height, and length dimensions. The meter housing 102 provides mechanical protection for metering circuitry included in the meter housing 102. The meter housing 102 may be configured as an IP51 enclosure as set forth by IEC 529, providing protection to the metering circuitry against inadvertent intrusion of tools and/or wires over 1 mm in diameter. The meter housing 102 also may provide protection against vertically falling drops of water, condensation and other moisture. The meter housing 102 may be designed to minimize holes, cutouts, spot welded tabs, folded seams, and connector openings, and may have a rust inhibiting coating such as a powder coat finish, paint or other protective coating. The meter housing 102 may provide mechanical protection, fire protection, electromagnetic protection against radio-frequency interference, and electrical shock protection.

The meter housing 102 may include a two-tiered surface 108 that includes a first portion 108a and a second portion 108b. In Figures 1-3, the first portion 108a is a front portion and the second portion 108b is a rear portion of the meter housing 102. The first portion 108a may be substantially planar across the width of the two-tiered surface 108, and extend a predetermined depth of the meter housing 102 from a front panel 104 of the rack-mounted meter 100 towards a mid portion 110 of the two-tiered surface 108. The second portion 108b, or slot, may be substantially planar across the width of the meter housing 102 and extend from the mid portion 110 to an end of the meter housing 102, such as a rear 112 of the meter housing 102. The second portion 108b may be recessed from the first portion 108a to form a slot.

The meter housing 102 may also include an electrical connector panel 106. The electrical connector panel 106 may include a first connector panel 106a and a second connector panel 106b. The first connector panel 106a may be a step or shoulder formed as a portion of the meter housing 102 that connects the first portion 108a of the two-tiered surface 108 to the second portion 108b. The first connector panel 106a may be substantially planar across the width of the meter housing 102, and may be positioned approximately orthogonal to both the first portion 108a and the second portion 108b of the two-tiered surface 108.

Figure 1 and 3 illustrate a metering options module 114 that is designed to be coupled with and mounted to the rack-mounted meter 100. Figure 2 illustrates the rack-mounted meter 100 without the metering options module 114 coupled with the rack-mounted meter 100. The enclosure of the metering options module 114 may be characterized by a width, height, and length dimensions. The metering options module 114 may include a housing that is designed to provide mechanical protection for circuitry enclosed within similar to that described above for the meter housing 102 of the rack-mounted meter 100. In the illustrated example, the enclosure of the metering options module 114 has six sides. In another embodiment, the metering options module 114 may include a housing that is completed after the metering options module 114 has been mounted to, or otherwise installed on, the rack mounted meter 100, e.g. the metering options module 114 features at least one open face that is covered by a face of the meter 100 when the metering options module 114 is installed. In this example, the metering housing 102 may be a sealed unit that is an IP51 enclosure as set forth by IEC 529. In addition, or alternatively, the housing formed by the combination of the metering options module 114, and the meter housing 102 may be an IP51 enclosure as set forth by IEC 529.

The metering options module 114 may be coupled with the rack-mounted meter 100 proximate the two-tiered surface 108. The surface of the second portion 108b of the rack-mounted meter 100 may be recessed from the surface of the first portion 108a a determined distance that allows the metering options module 114 to be mounted contiguous with the second portion 108b. In one example, the uppermost portion of the metering options module 114 may be substantially flush with the first portion 108a. That is, a height of the first portion of the first connector panel 106a is at least the height of an upper surface of the metering options module 114. In addition, the length of the second portion 108b may be at least as long as a length of the metering options module 114, and the width of the metering options module 114 may be no wider than the width of the rack-mounted meter 100. In the illustrated example, the length of the second portion 108b is slightly longer than the metering options module 114 to allow room for connectors and associated conductors, such as signal cables, to be terminated at the metering options module 114.

Accordingly, when the metering options module 114 is affixed to the meter 100, the metering options module 114 may be substantially flush with the upper surface 108a. In one example, the exposed upper surface of the metering options module 114 does not extend beyond the upper surface 108a. Additionally, or alternatively, the external dimensions of the meter 100 with the metering options module 114 mounted thereto may not exceed the maximum dimensions required for the meter 100 and the metering options module 114 to be installed in a bay of an equipment rack assembly. Thus, an outer envelop of the meter 100, with our without the metering options module 114, may be dimensioned to fit within the dimensions of a bay of an equipment rack assembly and be securely mountable therein.

The metering options module 114 may be coupled with the meter housing 102 with a fastener 117. The fastener 117 may be a screw, a rivet, a clasp, a latch, a snap, or any other mechanism capable of holding the metering options module 114 in position on a surface of the meter housing 102. In Figures 1-3, the fastener 117 is a plurality of fasteners each formed with a threaded post and a nut. In other examples, any other form of fastener, in any other position capable of coupling the metering options module 114 and the meter housing 102 may be used.

Figures 1 and 3 illustrate an example metering options module 114 mounted substantially flush with the two-tier upper surface 108 of the rack-mounted meter 100. In other examples, the metering options module 114 may be otherwise coupled with the rack-mounted meter 100. For example, the metering options module 114 and rack-mounted meter 100 may be configured with a two-tier side surface, or a two tiered bottom surface, where the metering options module 114 is mounted to be no greater than flush with the external dimensions of the rack-mounted meter 100. Alternatively, or in addition, additional external surfaces of the meter 100 may be two-tiered to allow more than one metering options module 114 to be mounted to the rack-mounted meter 114 and yet stay within the dimensions of a bay of an equipment rack.

The metering options module 114, when mounted on the meter 100, may have a first surface that is contiguous with the second surface 108b, and a second surface opposite the first surface that is substantially flush with the maximum external dimensions of the meter housing 102. Thus, first surface of the metering options module may be substantially parallel with a surface of the second portion, and the second surface of the metering options module 114 may be in substantially the same plane with the surface of the first portion 108a of the meter 100.

In another example, the meter housing 102 may have a slot, cavity or opening in which the metering options module 114 may be inserted. The slot may be formed in the front, back, top, bottom or side of the meter 100, and be an externally accessible surface of the metering housing 102. The meter housing 102 may form the cavity. The meter housing 102 may remain a sealed unit that is an IP51 enclosure as set forth by IEC 529. A hinged or otherwise movable cover, or trap door, may be positioned to cover an entrance to the cavity.

The cover may be moved from a closed position to an open position to allow the metering options module 114 to be inserted into the cavity through the entrance. The metering options module 114 may be securely held in the cavity with the cover. The cover may minimize entry of dust and moisture into the cavity. In addition, the cover may have a security mechanism such as a lock and key, a biometric device, such as a fingerprint scanner, or any other device that provides verification of identity so that only authorized personnel are allowed access to the cavity. In addition, or alternatively, the cover could be sealed with a tamper proof seal, such as a utility seal, and/or a revenue seal once the metering options module 114 is installed in the cavity and the cover is moved to a closed position. The number and type of tamper proof seal(s) is dependent on the operational functionality of the metering options module 114.

The metering options module 114 represents self-enclosed, sealed, additional functionality that may be added to the meter 100. Such functionality may include additional power parameter processing capability, signal conditioning capability, input/output capability, and/or any other hardware, firmware and/or software to reconfigure, enhance, or otherwise change the functionality of the meter 100. In one example, the metering options module 114 may provide enhanced communication capability and associated input/output hardware. In another example, the metering options module 114 may provide increased capability to transmit and receive input and/or output signals. In still other examples, the metering options module may provide hardware, software and input/output signal capability to enable protective relaying functionality. In yet another example, the metering options module 114 may provide power quality event hardware, software and input/output capability.

The front panel 104 of the rack-mounted meter 100 may have a flip-up cover 115. Figures 1 and 2 illustrate the rack-mounted meter 100 with the cover 115 in a closed position, and Figure 3 illustrates the cover 115 in an open position. The flip-up cover 115 may be hinged so that the cover 115 swings through an arc to an open position, exposing a control panel 116. At least a portion of the control panel 116 may be located underneath or behind the cover 115. Other portions of the control panel 116 may be accessible when the cover 115 is in a closed position. The control panel 116 may include connectors, such as analog, digital and/or optical connectors. In addition, as described later, the control panel 116 may include user interface devices, such as, buttons, knobs, switches or any other user input/output devices or mechanisms that provide access and control of the meter 100.

With the cover 115 closed, one or more connectors, buttons, switches, and/or other user interface devices for access and control of the meter 100 may be covered and inaccessible, while other connectors, buttons, switches, and/or any other user interfaces may be accessible through the cover 115. In addition, user interface devices may be included on the cover. Access to controls when the cover 115 is in the closed position may include only that functionality that will not affect operation. The remaining controls may be inaccessible to a user with limited security access when the cover 115 is closed. When additional control inputs are to be provided to the meter 100, the cover 115 may be opened, exposing the features beneath.

A screen 118, such as an LCD, LED, plasma or other digitally controlled display may be positioned on the front panel 104. The screen may be a touch-screen device allowing a user to input data and selections by touching appropriate areas on the screen 118. The screen 118 may be viewable with the cover 115 in the closed and opened positions. Thus, the screen 118 may be positioned on the control panel 116 or mounted on the cover 115. In one example, when the screen 118 is on the control panel 116, portions of the screen 118 may be blocked when the cover 115 is closed, e.g. to prevent viewing of particular data.

The screen 118 may include a graphical user interface that allows the user to input data, configure parameters for the meter 100, set controls, and/or receive information from the meter 100. The user may input a selection directly through the screen 118, and/or may input data using any one of combinations of the other user interface devices, such as buttons, switches and knobs included on the control panel 116. For example, using the buttons provided at the front 104 of the meter 100, the user may scroll or navigate through an options menu on the screen 118 to configure the meter 100, assign communications protocols for the meter 100, display output parameters, set input metering parameters and/or control any other features of the meter 100. The options menu may be a cascading or hierarchical menu where selections of options on a menu may provide a subset of options provided on another menu that is displayed to the user. The screen 118 may also be used to provide a visual indication of the operation of the meter 100.

The meter 100 may be configured to provide multiple levels of security to protect the meter 100 from being tampered with or inadvertently or mistakenly mis-programmed. For example, access to the options menu and/or portions of the options menu may be accessible only after a user has entered a password or authentication code. Similarly, where the meter 100 is being accessed for programming using an external processor in communication with the meter 100 through a communications port, access to programming features may be set according to a password entered. The password may be associated with a high-level programming or calibrating access, such as by a third party manufacturer and/or calibrator. Another authorization level may be associated with general configurations set-up. For example, another password may be associated with general scrolling or navigating to select various outputs, and/or restricting inputs or reconfiguring of the meter 100.

The level of access may be determined by a password or other authentication means, such as a biometric device, or any other mechanism for identifying a user. The meter 100 may be accessed by multiple users, each having a distinct password. Access to various parameters of the meter 100 may be determined or restricted by the password as well. For example, one user may have access only to power quality parameters based on the password associated with the user, and another user may have access to revenue parameters based on the associated password. The password also may restrict the user's privileges to read, or read and write data provided by the meter 100.

The front face 104 may be configured to be mounted and affixed to corresponding members of a standard equipment rack system. The front face 104 may have handles or grab bars 120 that allow an installer to carry the meter 100, and to position the meter 100 in or with an equipment rack assembly. The handles 120 may be installed at the front face 104 towards the vertical edges of the front panel 104. The front panel 104 also may include a mechanical coupler 122, such as a screw, bolt, or wing nut that allows the meter 100 to be affixed to a rack assembly. The mechanical coupler 122 may also be used to form a tamper proof seal, such as a utility seal so that the meter 100 cannot be removed from the equipment rack without disturbing, damaging, or otherwise changing the tamper proof seal to indicate such activity has occurred.

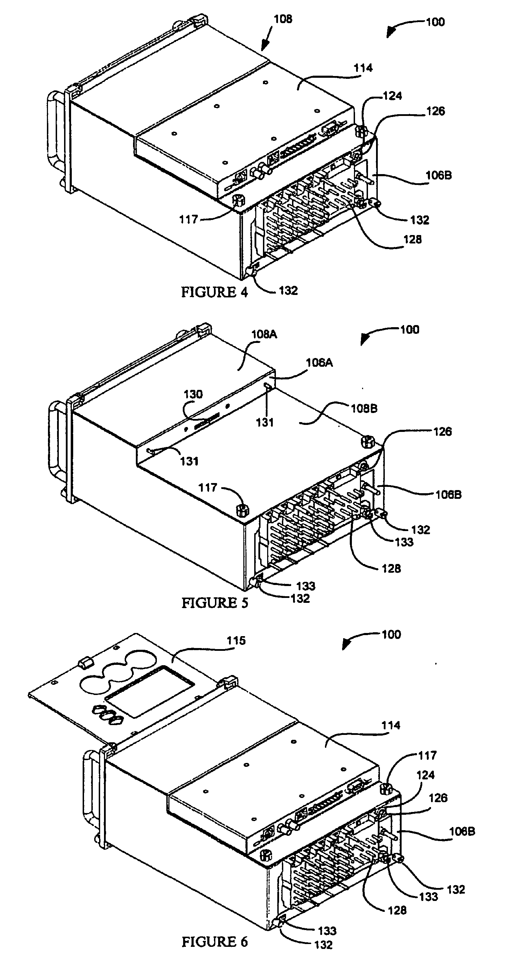

Figures 4-6 illustrate perspective views from the rear of the rack-mounted meter 100. Figures 4 and 5 illustrate the rack-mounted meter 100 with the cover 115 in a first position that is a closed position, and Figure 6 illustrates the rack mounted meter 100 with the cover 115 in an open position. Figures 4 and 6 illustrate the metering options module 114 attached or otherwise mounted to the rack-mounted meter 100 at the second portion 108b, and Figure 5 illustrates the rack-mounted meter 100 without the metering options module 114 mounted or otherwise affixed to the rack-mounted meter 100.

Figure 5 also illustrates the first connector panel 106a of the metering housing 102. An externally accessible meter housing electrical connector 130 may be installed on the surface of the first connector panel 106a to provide an electrical connection from the rack mounted meter 100 to the metering options module 114. In one example, the meter housing connector 130 is a multiple-pin connector providing power to the metering options module 114 as well as multiple I/O connections, such as communications and control signals. When the metering options module 114 is installed on the rack-mounted meter 100, a corresponding electrical connector is coupled with the meter housing electrical connector 130 on the rack-mounted meter 100. In one example, the meter housing connector 130 is a pin connector, such as a fifty pin connector, that is configured to accept an edge connector of the metering options module 114. The first connector panel 106a may also include guide pins 131. The guide pins 131 provide for mechanical alignment of the metering options module 114 with the meter 100 when the metering options module 114 is being positioned on the meter housing 102. The guide pins 131 may be provided at the first connector panel 106a to guide the metering options module 114 to the meter 100 when the metering options module 114 is mounted to the meter 100.

The rear of the meter housing 102 also may include the second connector panel 106b. The second connector panel 106b includes at least one rack electrical connector 128 for connecting the meter 100 to one more rack electrical connectors included in an equipment rack assembly. The rack connector 128 may be arranged according to a predetermined and/or standardized configuration or arrangement. In one example, the rack connector 128 may be a plurality of pins arranged according to a predetermined configuration where the position of a pin corresponds with a signal, power, or ground connection. Through the rack connector 128, signals related to the voltage and/or current of one of more conductors that the meter 100 may monitor or measure are inputs to the meter 100. The position of the pins of the rack electrical connector 128 may be assigned to a particular or discrete voltage, current, or power input signal. For example, a pin may be assigned to receive a voltage signal of one phase of a multiphase voltage system, a voltage signal of a single phase system, or a reference or neutral of a multi-phase or single phase voltage system. Similarly, a pin may be assigned to receive signals related to current on a conductor.

The rack electrical connector 128 may be one or more pin or plug-type connectors, sleeve or socket type connectors, or combinations thereof. The connector 128 may be coupled with one or more corresponding connectors in an equipment rack assembly (not shown) when the meter 100 is installed or otherwise mounted in a bay of an equipment rack assembly. The pins may be slid into corresponding sleeves or receptacles, and the sleeves may accept corresponding pins on the equipment rack assembly. In one example, the rack connector 128 includes multiple Essailec connectors, manufactured by ABB Entrelec of Irving, Texas, that are arranged in a predetermined configuration on the second connector panel 106b of the meter 100. The rack connector 128 may include coding or keying pins that mate with corresponding keying or coding pins on the rack electrical connector(s) in the equipment rack assembly when the meter 100 is installed in the bay of the equipment rack.

In one example, where the rack connector 128 is a plurality of Essailec connectors, there are a plurality of coding pins, such as four coding pins, associated with each Essailec connector. The coding pins may have an external contour or shape that provides a unique profile for the coding pin depending on the orientation of coding pin in its housing. The coding pin may be oriented in one of several clock positions with respect to the rack connector 128 with which it is associated. The coding pin will engage with the corresponding pin in the electrical connector in the equipment rack assembly, only when both pins have a corresponding orientation. The coding pins may be oriented or keyed according to the arrangement or layout of the rack connector 128 on the meter 100. The coding pins may therefore prevent a meter 100 from being mis-racked or installed in an improper socket on the equipment rack.

The coding pins also may be arranged to identify a configuration of the meter 100, and/or identify a feature set, or group of functionalities of the meter 100. The identified feature set may include parameters for how a particular meter 100 is configured and/or functionality provided by the meter 100. For example, the feature set may include digital input or output configurations, analog input or output configurations, Ethernet and communications configurations, GPS time sync capabilities, antenna connections for wireless devices (e.g., 802.11 and the like), wireless mesh networks, Zigbee, Wi-Fi, and the like. The coding pins may be assigned to each feature set such that a predefined coding pin, or arrangement of one or more coding pins, may identify the functionality present within a particular meter 100.

A ground lug 126 also may be provided on the second connector panel 106b of the meter 100 to provide grounding and bonding of the meter 100 to the equipment rack assembly. In one example, the ground lug 126 is a threaded stud in electrical continuity with exposed conductive members of the meter housing 102. The ground lug 126 also may be coupled with one or more grounded buses internal to the meter housing 102. In other examples, the ground lug 126 may be positioned elsewhere on the surface of the meter housing 102. In still other examples, one or more of the fasteners 117 may be used to ground the metering options module 114 and/or the meter 100.

The metering options module 114 may be coupled with the meter 100 with a tab 124 included on the metering options module 114. The tab 124 may be configured to be coupled with the ground lug 126. In Figures 4-5, the tab 124 includes an opening that allows the tab 124 to be slide over the ground lug 126 on the second connector panel 106b of the meter 100 and be fastened thereto with a fastener, such as a nut. The metering options module 114 may be secured, bonded and grounded with the power meter 100 through the electrical connection to the ground lug 126. In one example, the ground lug 126 is a threaded stud and the tab 124 of the metering options module 114 may be secured to the ground lug 126 through a paint breaking bonding nut that is secured to a threaded stud that forms the ground lug 126. The ground lug 126 may also be positioned to allow grounding and bonding of the meter 100 to an equipment rack assembly.

In one example, the second connector panel 106b of the meter 100 includes lances 132. The lances 132 may be projections formed in, or fasteners coupled with, the meter housing 102 on or in proximity to the second connector panel 106b of the meter housing 102. The meter 100 may include an internal chassis that is inserted or slid into the meter housing 102. In Figures 4-6, the lances 132 are screws that include an aperture, and may be used to fasten the internal housing to the meter housing 102. The lances 132 may be used to couple tamper-proof seals to the meter 100. The meter 100 may be assembled, calibrated and verified by a third party to be operational and to be capable of use to report on metering conditions and parameters within predetermined tolerances. Once verification is complete the internal chassis may be slid into the meter 100, and one or more tamper-proof seals may be applied to the lances 132. In one example, the ground lug 126 may also include a lance capable of being used to install a tamper-proof seal for the ground lug and/or the slidable chassis.

After the meter 100 has been verified to operate within determined tolerances, the meter 100 may be sealed with a tamper-proof seal. The tamper-proof seal may be a revenue seal that provides verification that the meter housing 102 has not been opened or otherwise disturbed following calibration. In one example, verification sealing of the meter 100 is completed by threading wire though one or more lances 132 in the second connector panel 106b of the meter 100. The ends of the wire that is threaded through the lances 132 may also be threaded through an aperture formed in a cleat 133 included on the meter housing 102. The cleat 133 may be positioned on the meter housing 102 and may be accessible after the meter 100 has been assembled. After the wire is threaded through the lance 132 and the cleat 133, the ends of the wire may be tied, clamped or otherwise permanently affixed together. The lance 132 also may be configured to secure the ends of the wires. Thus, in the illustrated example, the lance 132 cannot be unscrewed to access the internal chassis without breaking, or otherwise disturbing the wire threaded through the lance 132 and the cleat 133, which would indicate tampering had occurred.

A wire also may be threaded through a lance (not shown) in the metering options module 114 and secured to the meter 100 to create a tamper proof seal. The meter housing 102 of the meter 100 may not be opened without breaking, or otherwise creating indication of such activity with the tamper-proof seal. In addition, separation of the metering options module 114 from the meter 100 may not occur without breaking, or otherwise creating indication of such activity with the tamper-proof seal. In other examples, the tamper-proof seal may be omitted to enable discretionary removal and installation of the metering options module 114 without disturbing any tamper-proof seals.

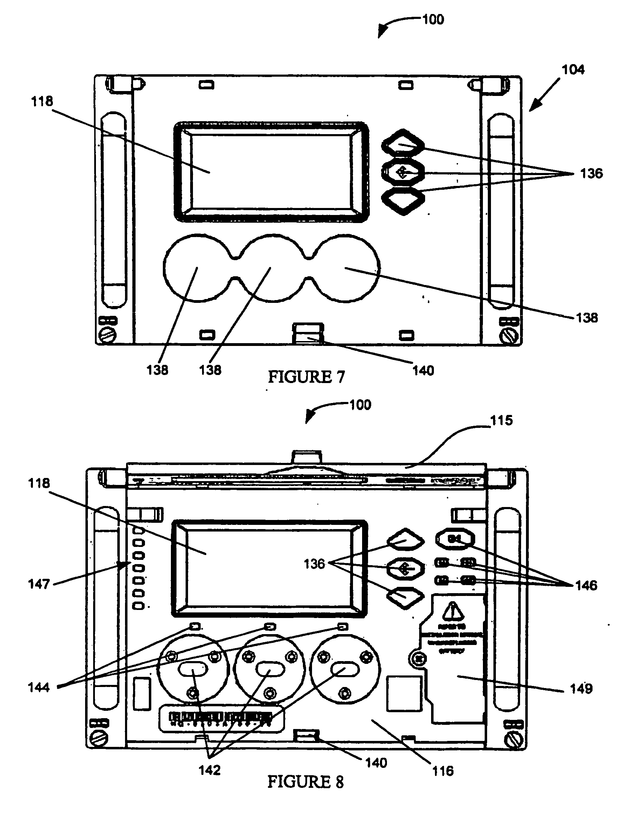

Figures 7 and 8 illustrate a front view of an example of the rack-mounted meter 100 that includes the front panel 104 of the meter 100. The front panel 104 provides a user interface for the meter 100. Figure 7 illustrates an example of the front panel 104 of the meter 100 with the cover 115 in a closed position. In the closed position, access to the user interface may be limited, however a set of input/control buttons 136 may remain accessible.

Figure 8 illustrates the front panel 104 of the meter 100 with the cover 115 in an open position, exposing input keys 146, indicators 147 (such as LEDs), and a battery cover or battery compartment 149, at least some of which may be concealed when the cover 115 is in a closed position. The cover 115 may be closed to conceal other buttons, switches, connectors, lights, and the like on the control panel 116. The cover 115 may be secured in the closed position by the weight of the cover 115, by a snap fit, by a mechanical coupler, or any other mechanism for securing the cover 115 in a closed position. The cover 115 may be configured to be open by hand or through the use of a specialty or off-the-shelf tool. The cover 115 may also be held in the closed position with a tamper-proof seal.

The display 118 is positioned at the front panel 104 to provide data input and output. The display 118 provides a graphical interface for the meter 100. Information gathered, metered, collected or otherwise compiled by the meter 100 may be displayed on the display 118. For example, the display 118 may display the current status of power used by a load being monitored by the meter 100. The display 118 may also provide a visual or graphic display of a phasor diagram for the load and/or supply. A user may also use the display 118 to input control commands to the meter 100 and/or scroll through an options menu to configure the meter 100, set metering parameters and alarm conditions, select communications protocols, assign communications protocols to input/output communications ports, and/or select an output from the meter 100 for viewing, control and/or further processing.

The display 118 may be used in combination with scroll buttons 136 to scroll through the menus of the meter 100. In one example, the display 118 is a touch screen that allows the user to input commands, and otherwise make selections from an options menu using the display 118. The display 118 may also be configured to recognize or identify the user, and grant access to features, functions and parameters of the meter 100 based on recognition of the user. For example, the display 118 may be configured to recognize or identify a user by analyzing the user's biometric data, such as a fingerprint, when the user touches the screen 118. The meter 100 may include a fingerprint recognition mechanism that allows identification of a user's fingerprint. After the user is recognized, the level of access to features and functions of the meter 100 may be determined based on a predetermined authorization level. Accordingly, the user's biometric information may be used for granting access and determining access levels for the user within the meter 100.

The display 118 also may provide a visual indication of an alarm condition. For example, the display 118 may be configured to have a selected background color during operating conditions, and another distinct background color when an alarm condition is detected. The background color of the display 118 may change color and/or flash when an alarm condition is detected. For example, if the meter 100 detects a power outage, a low voltage condition, an overload condition, or measure a parameter outside a preset limit, the meter 100 may indicate the corresponding alarm condition on the display 118 by changing the background color on the display 118. A message also, or alternatively, may be flashed on the display 118. The visual alarm indicator of the display 118 may be accompanied by an audible alarm and/or a communications output indicating the detected alarm condition.

The user may select from a variety of communications protocols over which the meter 100 may communicate with other devices, such as computers, processors, controllers, loads and meters. The user may select the communications protocol from a selected menu displayed on the display 118. The communications protocol also, or alternatively, may be set from a computer or other controller coupled to the meter 100, either through a rack assembly, at the factory during assembly, through a universal serial bus ("USB") port, through an optical port, through a hard-wired connection, or through a wireless communications transmission with the meter 100. The meter 100 may be configured to communicate using one or more communications protocols, including TCIP, SCADA, Modbus, ION, RS232, RS485, and Device Language Message Specification ("DLMS"), DNP, IEC 61850 protocols and the like.

The front panel 104 may include one or more optical communications ports 142. In one example, the optical communications ports 142 are configured according to IEC 1107, ANSI C12, and/or IRDA standards. The optical communications ports 142 may be accessible through openings 138 in the cover 115. The optical communications ports 142 may provide access to communications with the meter 100 through the user interface provided by the front panel 104 of the meter 100.

The optical communications ports 142 may also be configured to provide parallel communications. Thus, in the example of Figure 8, each optical communications port 142 may be configured to independently communicate with a communications device external to the meter 100. The optical communications ports 142 also may be configured to provide series communications. The series communication may be duplicative of communications of one of the other ports 142. Thus, using the optical communications port 142, the meter 100 may be configured to communicate with a plurality of external devices, such as three different devices.

The communications ports 142 may each have a communications indicator 144 that signals when communication with the corresponding port 142 is active, such as through a visual indication. In one example, the communications indicator 144 is one or more LED's positioned proximate to the optical communications port 142. The communications indicators 144 may illuminate when the corresponding communications port 142 is active. Each of the communications indicators 144 may be encased in a clear diffuser positioned around each of the optical communications ports 142. The diffuser may be illuminated when the corresponding communications indicator 144 illuminates. The communications indicator 144 may be configured to distinguish between inbound and outbound communications, such as by corresponding distinguishing colors. The communications indicator 144 also may be configured to provide a visual indicator when the communications is lost or to indicate an alarm condition, such as by flashing.

The front panel 104 also may provide a universal serial bus (USB) port 140 for wired communications with other devices. The USB port 140 enables the meter 100 to be connected to any USB compatible device, such as, for example, portable computers and portable communications devices. The meter 100 also may be configured for wireless communications, such as by using Wi-Fi, Bluetooth, mesh and Zigbee standard communications protocols and/or combinations thereof. Using the wireless communications, and/or USB port, the meter 100 may communicate and share data and control with other devices.

The meter 100 may have a redundant, back-up power supply or reserve energy storage device (not shown). The redundant power supply may be available to provide power for the operation of the meter 100 in the event of a power supply failure to the meter 100. The redundant power supply may automatically take over supplying power to the meter 100 in the event of a power failure. In one example, the back-up power supply is a battery back-up.

In the event of a power failure, the meter 100 may sense the power failure and switch over to the back-power supply. The meter 100 also may enter into a power down or sleep mode until electrical energy is sensed on the conductor(s) being monitored by the meter 100. Figure 8 illustrates an example of a battery compartment 149 which may provide an enclosure for one or more back-up batteries. The battery compartment 149 is concealed by the cover 115 and is accessible only when the cover 115 is open. In another example, the back-up power supply may be a capacitor or capacitor bank that may store energy that may be used in the event of a power failure. The meter 100 also may be powered by one or more phases of the power supplied on the conductor(s) to which the meter 100 is connected to monitor. The meter 100 also may have a dedicated AC power supply or dedicated DC supply from a stationary battery.

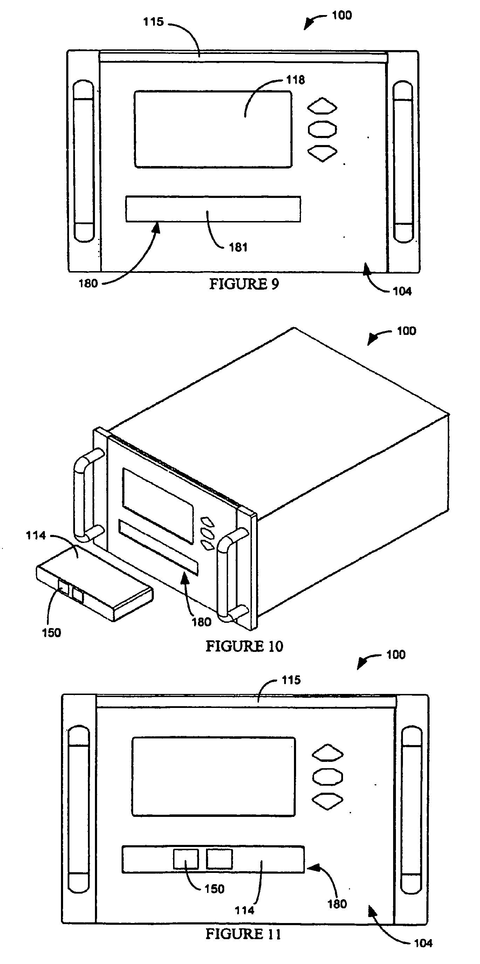

Figure 9 illustrates a front view of another example of the rack-mounted meter 100 that includes the front panel 104 of the meter 100. In this example, the cover 115 is illustrated as open, and in addition to the user interface devices, such as the display 118, the front panel 104 includes a slot 180 formed in the front panel 104. The slot 180 may be formed in an externally accessible surface of the meter housing. The meter housing may remain a sealed unit that is an IP51 enclosure as set forth by IEC 529.

The slot 180 may be dimensioned to receive the metering options module 114. The slot 180 may have a removable and/or retractable slot cover 181 that covers an opening to the slot 180. The meter housing electrical connector 130 (Figure 5) may be disposed in the slot 180 and positioned to engage an electrical connector mounted on the metering options module 114.

Figure 10 is a perspective view of an example meter 100 that also includes a perspective view of a removable metering options module 114. In this example, the metering options module 114 is dimensioned to fit within the slot 180. Thus, the two-tiered surface 108 (Figure 1) may be omitted. The metering options module 114 may include a plurality of input/output (I/O) ports 150. As described later, the I/O ports 150 may provide an interface to other devices and/or equipment.

Figure 11 is a front view of the meter 100 of Figure 9 with the metering options module 114 installed in the slot 180. The I/O ports 150 may be positioned to be accessible when the cover 115 is in the open position. A tamper-proof-seal may be applied once the metering options module 114 is positioned in the slot 180. An electrical connector (not shown) mounted on a surface of the metering options module 114 may be positioned to engage a surface mounted electrical connector disposed in the slot 180 when the metering options module 114 is positioned in the slot 180. The I/O ports 150 may also include a ground lug. Alternatively, or in addition, the metering options module 114 may be grounded when the electrical connectors engage within the slot 180.

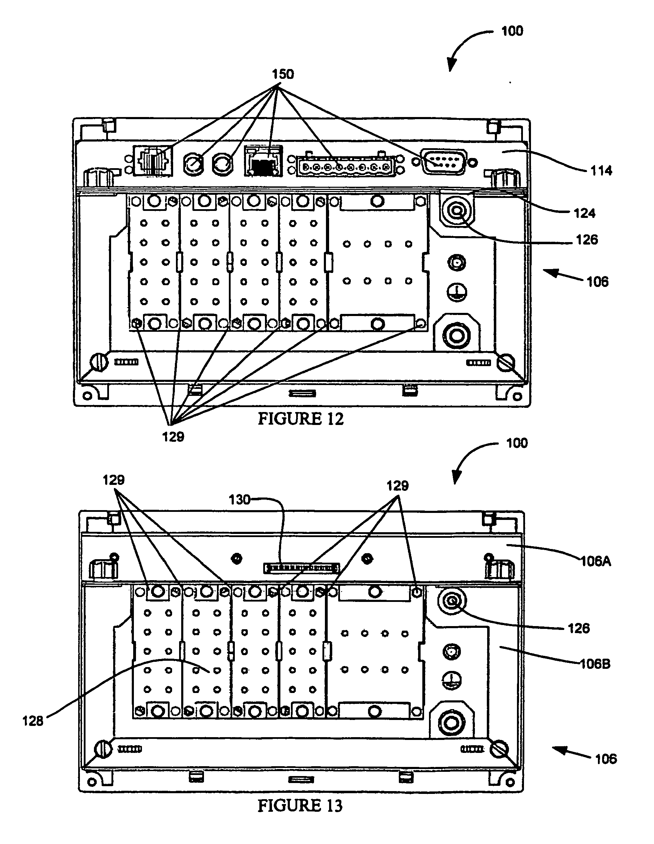

Figures 12 and 13 illustrate rear views of an example of the rack-mounted meter 100 also illustrated in Figures 1-6. Figure 12 illustrates the rack-mounted meter 100 with the metering options module 114 attached or otherwise coupled with, or mounted to an externally accessible surface of the rack-mounted meter 100, and Figure 13 illustrates the rack-mounted meter 100 without the metering options module 114 coupled, mounted, or otherwise affixed to the rack-mounted meter 100.

Figure 12 also illustrates one or more I/O ports 150 included on a rear panel of the metering options module 114. The I/O ports 150 may be communication ports that are enabled for communication when the metering options module 114 is coupled with the meter housing 102. Alternatively, or in addition, the I/O ports 150 may be signal ports, such as analog and/or digital signal ports. In other examples, the I/O ports 150 may be on any other surface of the metering options module 114.

In another example, the I/O ports 150 may be in the form of one or more options rack electrical connectors. The options rack electrical connector(s) may be formed and position on the rear panel of the metering options module 114. In other examples, the options rack electrical connector may be positioned on any other externally accessible surface of the metering options module 114.

When the metering options module 114 is mounted on the meter 100 and racked into a bay of an equipment rack, the options rack electrical connector may be engaged with an options rack electrical connector included in the equipment rack. Upon engagement, inputs and/or outputs external to the meter 100 and/or the metering options module 114 may be provided to the metering options module 114 via the engaged options rack electrical connectors. The options rack electrical connectors may be pluggable panel mount connectors which may include wiring harnesses, or any other form of electrical connectors, as discussed herein. In one example, the pluggable panel mount connectors may be Essailec connectors. The options rack electrical connectors in the equipment rack may be pre-wired in a predetermined configuration, and/or may be installed and wired for the metering options module 114.

The meter 100 may be configured as an intelligent electronic device (IED). As an IED, the meter 100 may be configured to provide control of other devices in a Master/Slave arrangement. In one example, the meter 100 is configured to communicate with other metering devices using a Modbus and/or Modbus TCP communications protocol to provide control functions for those devices. The meter 100 may be set up as a Master where other devices on the network are slaves. The slaves may communicate information back to Master. The Master (meter 100) may handle communication of the information through the network to other network coupled devices, such as controllers. The meter 100 also may be compatible with an object-oriented architecture.

The meter 100 also may have modular capability so that it may be configured to operate according to a limited set of functions. Examples of such IED, object-oriented architectures, master/slave power monitoring devices, and module configurations for power meters are described in US Patent No. 6,871,150, entitled Expandable Intelligent Electronic Device, US Patent No. 5,650,936, entitled Power Monitor Apparatus and Method With Object Oriented Structure, and US Patent No. 5,828,576, entitled Power Monitor Apparatus and Method With Object Oriented Structure, each of which is incorporated by reference in its entirety herein.

Figure 13 illustrates the first connector panel 106a of the meter housing having the externally accessible meter housing electrical connector 130 for providing electrical connection to the metering options module 114. The externally accessible meter housing electrical connector 130 may be installed on the first connector panel 106a to provide an electrical connection from the rack mounted meter 100 to the metering options module 114. The electrical connector 130 may provide electrical connections to a corresponding electrical connector on the metering options module 114.

As shown in Figures 12 and 13, the second connector panel 106b of the meter housing 102 may provide rack electrical connector 128 for use with the equipment rack assembly. The rack electrical connector 128 may be one or more electrical connectors arranged in a standard configuration at the second connector panel 106b of the meter 100. The rack electrical connectors 128 may be configured to be coupled to, or engaged with, corresponding rack electrical connectors provided in the equipment rack assembly in which the meter 100 may be mounted. The electrical connectors may have a standard arrangement, or configuration, where the position of an electrical connector corresponds with a signal, power, or ground connection in the equipment rack assembly. For example, the connectors are pins that are slid into corresponding sleeves or receptacles on the rack assembly, as previously discussed.

In one example, the electrical connectors are Essailec connectors that are keyed or arranged to provide an advanced feature set for input and output between the meter 100, the equipment rack assembly, and/or devices connected to the meter 100 through the equipment rack assembly. One end of the Essailec connectors may be mounted and coupled to one or more printed circuit boards. Each printed circuit board includes traces that route connections to the connector from a common connection point on the printed circuit board for all connectors. The printed circuit board may be installed on the chassis of the meter 100, and internal connections to the Essailec connectors may be made through the circuit board to internal connectors of the meter 100. Mounting the Essailec connectors to the circuit board provides an efficient quick means for installing or otherwise assembling the connectors in the meter 100.

The meter 100 may include a map of the rack connector(s) 128 stored in memory. The map may be used by the processor to determine whether appropriate connections are made when the meter 100 is installed in the equipment rack. For example, the meter 100 may be programmed to detect whether the Essailec pins are connected to a circuit when the meter 100 is installed in the equipment rack assembly. In one example, a lookup table may store a bitmap of the connections of the rack connector(s) 128. When the meter 100 is installed and configured by a user, the bitmap may be referenced to ensure that the expected connections at the rack connector(s) 128 are present. The expected connections may be determined based on measurement of signal and/or voltage levels, measurement of test signals transmitted through the connections, or any other method, mechanism or device capable of determining that the connections are present. For example, if a connection is measured expecting between 100V and 120V, and that is what is measured, the connection is verified.

Connection verification may also involve the metering options module 114 for certain signals, such as communication signals. In addition, the metering options module 114 may be used to generate and/or enable the generation of test signals to verify the connections. For example, the metering options module 114 may be in communication with an external device capable of generating test signals to the connections in the equipment rack. Thus, the metering circuitry may direct the external device via the metering options module 114 to output test signals to verify the connections.

If the expected connection is not present, an alarm or other indicator may be generated by the metering circuitry. For example, a message may be displayed to a user through the screen 118. (Figure 8) The meter 100 also may be configured to display a map of the rack connector(s) 128 on the screen 118.

In one example a user may select to display a map of the connections on the screen 118. The map may be displayed to show which of the connectors/pins has an electrical connection, when inserted in a bay of an electrical equipment rack. A pin having an electrical connection may be displayed in the map with a color or shading different from a pin without an electrical connection. For example, all connectors having electrical connections may be illustrated as black dots on the map and those connectors without a connection may be displayed in the map as a circle. Alternatively, or in addition, a signal level value of each connector/pin having an electrical connection may be displayed.

At least one of the rack connectors 128 located at the second connector panel 106b of the meter 100 may be configured to provide an analog input/output connection. The analog I/O connection may provide analog communications signals between the meter 100 and other devices. The analog connection may be used t provide information from the meter 100. Additionally or alternatively, the analog connection may be used to receive information by the meter 100.

One example, connection to an analog I/O pin may enable the meter 100 to be aligned with absolute time, independent of an operating system time of the meter 100. Therefore, an analog pin may be used as a port for a global positioning system (GPS) signal for purposes of time synchronization. Using IRIG GPS signals, the input signals to the meter 100 may be time-stamped and synchronized. The IRIG GPS signal may be continuously monitored by the meter 100, or sampled. In one example, an IRIG B GPS signal is received by the meter 100. A Field Programmable Gate Array ("FPGA") included in the metering circuitry may decode the received IRIG B signal, and generate an interrupt signal at a fixed time relative to the start of an IRIG B packet. A processor, such as a CPU, may receive or detect the interrupt and thereby generate an accurate time stamp. The processor reads the IRIG B packet from the FPGA. The IRIG GPS connection on the rack-mounted meter 100 also may be provided through other connections to the meter 100 such as wireless transmission and/or reception, IRIG B, and serial communications.

Another connection supported by the rack connector(s) 128 may be a watchdog signal generated by the metering circuitry included in the meter 100. For example, a "heartbeat" signal may be periodically provided at one of the connections. The heartbeat signal may be present when the meter 100 is operational and/or operating. The signal may be monitored by an external controller or processor. When the meter 100 is not operating or operational, the heartbeat signal will cease, triggering an alarm or other indicator that the meter 100 may have failed or may be in the process of failing.

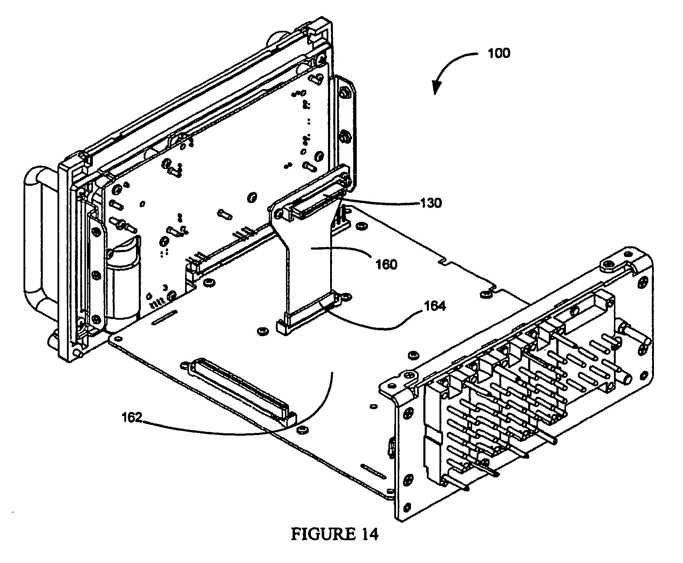

Figure 14 illustrates a perspective view of an example of the meter 100 with a portion of the meter housing 102 removed to show internal connections and configuration of the meter housing electrical connector 130. As previously discussed, the meter housing electrical connector 130 is positioned to engage an electrical connector on the metering options module 114 when the metering options module 114 is coupled with the meter housing 102.

The meter housing electrical connector 130 may be internally coupled to a bus 160. The bus 160 may provide electrical connectivity from the meter housing connector 130 to metering circuitry 162 included in meter 100. In Figure 14, the bus 160 is coupled with an internal printed wiring/circuit board that is included in the metering circuitry 162.

In one example, the bus 160 includes an intermediate printed circuit board that conducts the signals between the meter 100 and the metering options module 114. In other examples, the bus 160 may be a plurality of wires, a serial bus, a universal asynchronous receiver transmitter (UART), or any other mechanism capable of communicating electrical signals. The bus 160 may provide a conduit for the signals between a processor, controller, field programmable gate array (FPGA) and/or CPU and other components included in the metering circuitry of the meter 100 and a processor, controller, and/or central processing unit (CPU) and other components of the metering options module 114. The bus 160 may terminate at one end in a multiple pin connector such as a 50 pin header (meter housing connector 130) that is configured to engage the metering options module 114. The other end of the bus 160 may be terminated in a metering circuitry connector 164, such as an edge connector. In one example, the bus 160 may be coupled with an edge connector that is a 50 pin header on a CPU circuit board included in the metering circuitry 162 of the meter 100. The bus 160 therefore extends from the metering circuitry 162, such as a main CPU board to the meter housing connector 130 positioned in the first connector panel 106a formed in the meter housing 102 of the meter 100.

In one example, the metering circuitry 162 of the meter 100 includes the base circuitry for the meter 100. The base circuitry may be that metering circuitry needed to perform revenue and power quality calculations. The metering circuitry 162 may include a CPU board having programmable processors, controllers, ASIC's, logic units, memory components gates, logic components and other devices configured to perform power metering functions, and enable features and functionality of the meter 100. The metering circuitry 162 may include expansion ports or connectors (not shown) to allow functionality of the metering circuitry 162 to be enhanced and/or expanded. At least a portion of the metering circuitry 162, such as a CPU board, also may be removable from the meter 100 and/or replaceable.

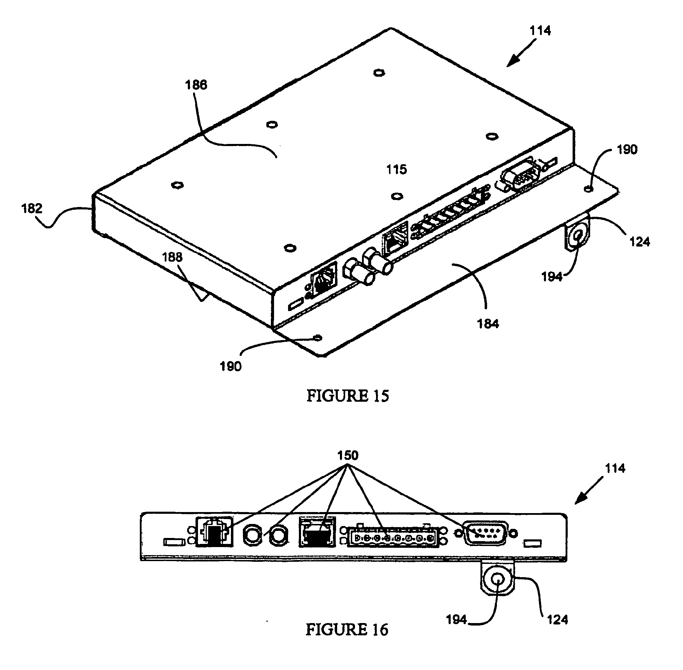

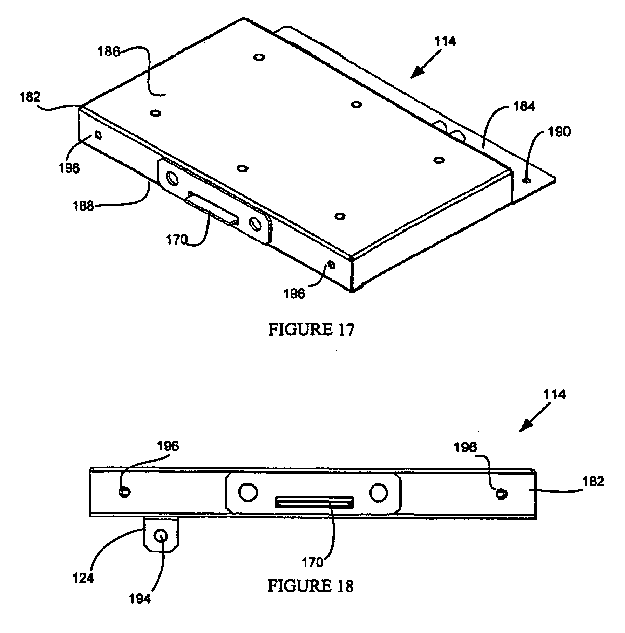

Figure 15 illustrates a perspective view from the rear of an example of the metering options module 114, and Figure 16 illustrates a rear view of an example of the metering options module 114. Figure 17 illustrates a perspective view from the front of an example of the metering options module 114, and Figure 18 illustrates a front view of an example of the metering options module 114. As shown in Figures 15-18, the metering options module 114 includes a module electrical connector 170 that is configured and positioned to engage with the meter housing electrical connector 130 on the surface of the meter 100 when the metering options module 114 is coupled with the meter housing 102.

The metering options module 114 is configured to provide optional and/or enhanced features and/or functionality for the meter 100. For example, the metering options module 114 may provide desired features and functionality for the meter 100 beyond the base features of the meter 100. The metering options module 114 additionally or alternatively may be designed to implement one or more discrete features that are useable by the meter 100. As the needs for the meter 100 change, the metering options module 114 may be changed to update or otherwise change the functionality of the meter 100.

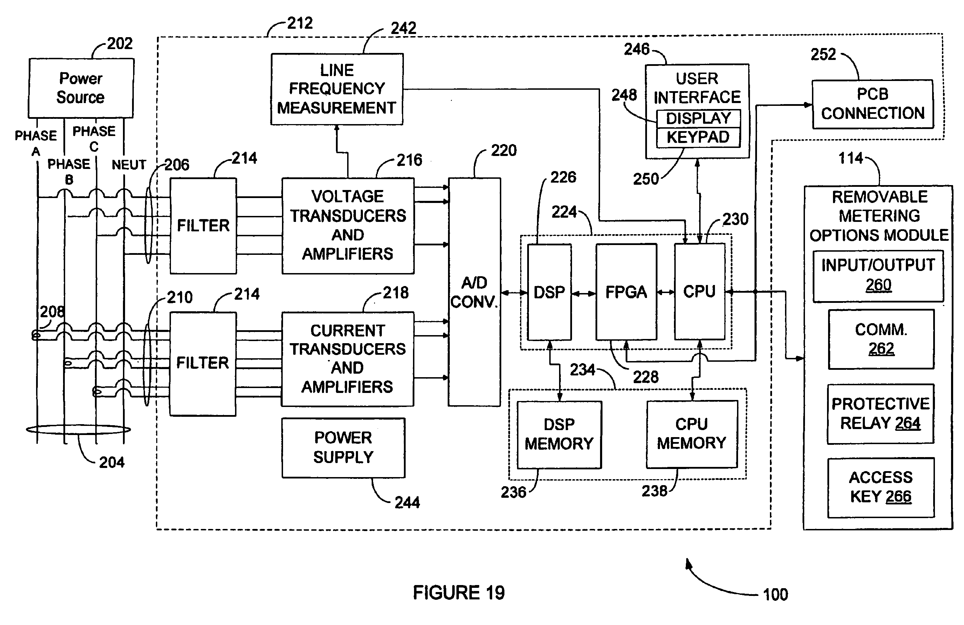

Figure 19 is an example block diagram of the functionality of a meter 100 that includes a metering options module 114. In Figure 19, a three phase power source 202 includes a plurality of conductors 204. The conductors 204 may feed a load or a portion of a power system. The rack mounted meter 100 may be coupled with the conductors 204 to receive and measure electrical parameters of electrical energy present in the conductors 204. A plurality of voltage metering lines 206 may be coupled with the conductors 204 and the meter 100 to provide voltage signals indicative of the frequency, magnitude, and phase of the voltage present on one or more of the conductors 204. The meter 100 may also include a plurality of current transformers (CTs) 208. Alternatively, the CTs 208 may be separated away from the meter 100. The CTs 208 may provide current signals on a plurality of current lines 210. The current signals may be indicative of the magnitude of current flowing in the one or more of the conductors 204.

The voltage and current signals may be provided to metering circuitry 212 included in the meter 100. Within the metering circuitry 212, the voltage and current signals may each be fed to a filter 214. The filter 214 may reduce noise, transients, harmonics and any other undesirable signal content that may be present on the voltage lines 206 and the current lines 208. In one example, the filters 214 may be low pass filters. In another example, the filters 214 may be unnecessary, and may be omitted. The filtered or unfiltered voltage and current signals may be modified by adjusting the magnitude and/or format with a respective voltage transducer/amplifier 216 and a current transducer/amplifier 218. In another example, the filtered or unfiltered current and voltage signals may be used directly without modification and the voltage transducer/amplifier and/or the current transducer/amplifier 218 may be omitted. The filtered and modified voltage and current signals may be converted from analog to digital signals with an analog to digital converter 220, and provided to a processor 224.

The processor 224 may include a digital signal processor (DSP) 226, a field programmable gate array (FPGA) 228, and a central processing unit (CPU) 230. In other examples, one or more, or any combination of the DSP 226, the FPGA 228 and the CPU 230 may be used to form the processor 224. The processor 224 may direct the operation of the meter 100. In addition, the processor 224 may process the electrical parameters measured from the conductors 204. A memory 234 may include a DSP memory 236 and a CPU memory 238. The memory 234 may include volatile and/or non-volatile memory. The memory 234 may store instructions executable by the processor 224. In addition the memory may store power parameters, both measured and calculated by the processor 224, user profiles, passwords, configurations, and/or any other data related to meter and power quality functionality.

The metering circuitry 212 may also include a line frequency measurement module 242, a power supply 244 and a user interface 246. The line frequency measurement module 242 may be coupled with the voltage transducer/amplifier 216 and the processor 224. Based on the filtered and modified voltage signal, the line frequency measurement module 242 may generate a line frequency signal representative of the voltage present in the conductors 204. The line frequency signal may be provided to the processor 224. The power supply 244 may be powered by the conductors 204, an auxiliary supply of power, and/or a back up supply of power. The power supply 244 may produce one or more voltages to power the metering circuitry 212. In addition, the power supply 244 may supply power to the metering options module 114. The user interface 246 may include a display 248 and a key pad 250. In other examples, the user interface 246 may include any other device and/or mechanism that provides a man machine interface to the meter 100 and/or other devices in communication with the meter 100.

The metering circuitry 212 may also include a printed circuit board connection 252. The printed circuit board connection 252 may provide an interface to the rack electrical connectors 128 as previously discussed, and be coupled with the processor 224. In another example, the printed circuit board connection 252 may be external to the metering circuitry 212.

The removable metering options module 114 may also be coupled with the metering circuitry 212. As previously discussed, the metering options module 114 may include an electrical connector 170 (Figure 18) that is positioned to engage an electrical connector on a surface of the metering housing. The metering options module 114 may change the functionality of the metering circuitry 212 and/or the processor 224. In Figure 19, the metering options module 114 includes one or more of an input/output module 260, a communications module 262, a protective relay module 264, and an access key module 266.

The input/output module 260 may provide the capability to add additional inputs and/or outputs to the meter 100. Accordingly, the metering options module 114 may be configured to include circuitry and other hardware needed to provide such additional functionality.

The metering options module 114 may also include a power supply backup functionality. For example, the metering options module 114 may include a battery or other energy storage device that is a backup power supply. The backup power supply may be configured to supply power to the metering options module 114. In addition, the backup power supply may be configured to supply power to the meter 100. In the event of loss of power to the meter 100, the backup power supply included in the metering options module 114 may be automatically activated, switched, or otherwise enabled to provide a supply of power to the meter 100 and the metering options module 114. The backup power supply may power the entire meter 100 and metering options module 114 when enabled to supply power.

Alternatively, the backup power supply may power only some of the functionality of the meter 100 or metering options module 114. For example, the backup power supply may provide power to only the processor 224 to allow communication of a loss of power alarm, or to only that portion of the metering circuitry 212 that will enable continued collection and storage of measured data. Any form of partial powering scheme that prolongs the life of the energy storage device included in the backup power supply may be employed to maintain a desired functionality of the meter 100 and/or metering options module 114 upon loss of the main power source.

Alternatively, or in addition, the backup power supply may include monitoring capability of the energy storage device included with the backup power supply. The meter 100 and/or metering options module 114 may include the capability to sequentially power down predetermined and/or pre-selected functionality within the meter 100 and/or the metering options module 114 at predetermined stages, or thresholds, of depletion of the energy storage device.

The backup power supply may be accessible from outside the metering options module 114 to allow replacement and/or testing of the backup power supply, as well as replacement and/or testing of the energy storage device included therewith. Replacement and/or testing of the backup power supply may be accomplished without disturbing any tamperproof seals included on the metering options module 114 and/or the meter 100.

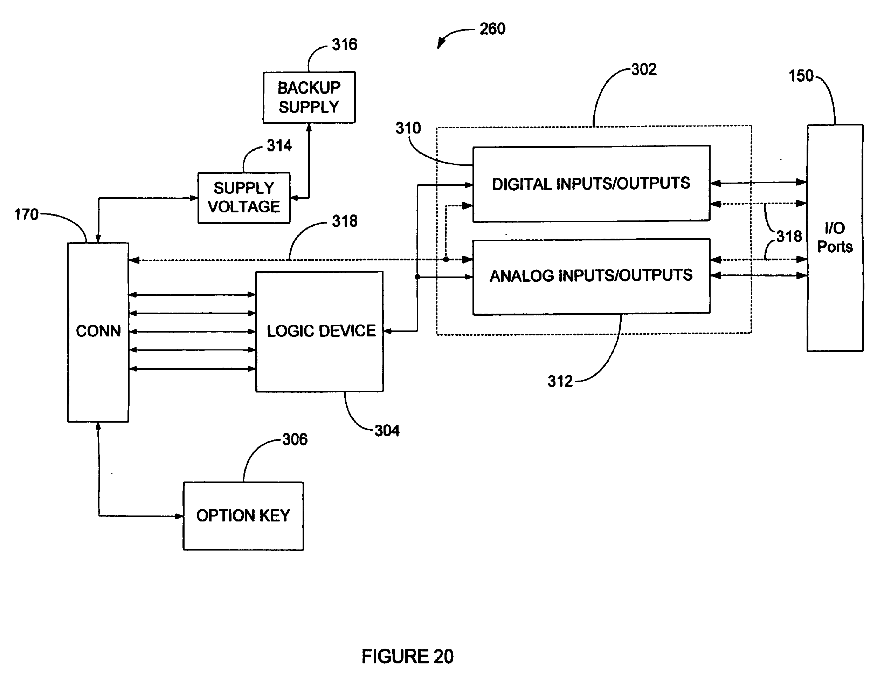

Figure 20 is a block diagram illustrating the functionality of an example input/output module 260 that includes a signal processing module 302, a logic device 304, and an option key 306. In other examples, additional or less hardware, modules and/or functionality may be included in the input/output module 260. The signal processing module 302 may provide digital and/or analog signal processing capability, which may include filtering, analog-to-digital conversion, signal isolation, signal conversion, etc.

In the illustrated example, a digital input/output module 310, and an analog input/output module 312 are illustrated to represent processing, receipt and/or transmission of any form of digital and/or analog signals, such as pulse signals, 4-20ma signals, 1-5 volt signals, and/or any other form of digital or analog signal. The digital input/output module 310 and the analog input/output module 312 may be coupled with the I/O ports 150. The I/O ports 150 may include connectors, terminals strips and/or any other form of coupling mechanism capable of providing a signal interface to devices external to the metering options module 114. The digital input/output module 310 and the analog input/output module 312 also may be coupled with the logic device 304.

The logic device 304 may be any mechanism or device capable of providing an interface between the digital input/output module 310 and the analog input/output module 312 and the metering circuitry 212 (Figure 19). In one example, the logic device 304 is a programmable logic device that is programmed to operate as a multiplexer. In other examples, the logic device may be a buffer, a UART, etc. The logic device 304 may be configured to communicate I/O signals between the digital input/output module 310 or the analog input/output module 312 and the electrical connector 170 mounted on a surface of the metering options module.

The option key 306 also may be coupled with the electrical connector 170. The option key 306 may be in communication with the processor 224 (Figure 19) via the electrical connector 170. The option key 306 may identify to the processor 224 that the metering options module includes the I/O functionality. Thus, when the metering options module is coupled with the electrical connector 130 (Figure 5) on the meter housing 102 (Figure 1), the processor is able to determine what functionality has been added/changed. In one example, the option key 306 may include a plurality of option resistors which are configured to identify the additional functionality added by the metering options module. In other examples, a memory, a dip switch, or any other mechanism or device may be used to identify the metering options module to the processor. The option key may also define the I/O ports 150, ranges of the I/O signals present on the I/O ports 150, and/or provide any other information related to the processor 224 (Figure 19) cooperatively operating with the metering options module.

The electrical connector 170 may also provide one or more supply voltages 314. The supply voltages 314 may be provided from the power supply 244 (Figure 19) included in the metering circuitry 212 (Figure 19) to power devices, providing wetting voltages, etc. In addition, the supply voltage 314 may provide power to a backup power supply 316 included in the metering options module when the power supply 244 (Figure 19) is being powered. The backup power supply 316 may include an energy storage device, such as a battery, that is maintained in a fully charged state by the supply voltage 314. The backup power supply may include a voltage sensing device to sense the voltage levels and quality of the supply voltage 314. Upon loss of power to the supply voltage 314, or degradation of the quality of power supplied to the supply voltage 316 below a predetermined level, the backup power supply 316 may be enabled to supply backup power to the meter 100 and the metering options module 114. As previously discuss, the backup power supply may energize all or portions of the meter 100 and/or the metering options module 114.

The electrical connector 170 may also be coupled with the digital input/output module 310 and/or the analog input/output module 312 via one or more dedicated signal lines 318. The dedicated signals line(s) 318 may also couple the digital input/output module 310 and/or the analog input/output module 312 to the I/O ports 150. The dedicated signal line(s) 318 may transmit signals directly between the I/O ports 150, the digital input/output module 310 and/or the analog input/output module 312, and the metering circuitry 212 (Figure 19) without processing the signals in the respective digital input/output module 310 and the analog input/output module 312 or through the logic device 304.

For example, the digital input/output module 310 may selectively operate in three modes to process one or more input signals on one or more respective channels. The three modes may be operated simultaneously, and/or in any combination within the digital input/output module 310. A first mode may be a pulse mode, and a second mode may be a KYZ mode. In the first and second modes the digital input/output module 310 may operate to detect a DC level of a signal being received as an input. The input signal may be digitized by the digital input/output module 310, and then further processing within the digital input/output module 310 may occur based on the DC levels that were sampled.

A third mode may be an "AC" mode in which time varying input signals are received and processed. In the third mode, the digital input/output module 310 may operate to provide received AC input signal(s) to the metering circuitry 212 (Figure 19). The metering circuitry 212 may rectify the AC input signal(s) and then digitize the input signal(s) for further processing. The signal(s) may be further processed with the metering circuitry 212 based on the sampling frequency applied during digitization. If an input signal is within a predetermined frequency range on a given channel, the status of that channel may be indicated as "ACTIVE" by the metering circuitry 212.

The AC input signals may be provided from the I/O ports 150 on the dedicated signal line(s) 318 to pass through the digital input/output module 310 without processing to the metering circuitry 212. The AC input signals may be rectified, digitized, and further processed using code, such as firmware stored in memory 234 (Figure 19). The firmware may be executable by the processor 224 (Figure 19) included in the metering circuitry 212. For example, a sine wave input signal may be rectified, and a peak of each half cycle may be detected during sampling. In one example, AC input signals passed through the digital input/output module 310 may be timestamped with a high accuracy timestamp similar to other DC digital inputs, before being passed to the metering circuitry 212 to be processed. Because the timestamp can be implemented in the digital input/output module 310, and the processing of the AC input signal may occur with firmware in the metering circuitry, both DC and AC digital inputs may be processed using the same hardware, namely, the digital input/output module 310. In addition, since the AC input signals are processed with firmware in the metering circuitry 212, processing of the AC input signals may be flexibly selected and varied by updating and/or changing the configuration of the code included in the firmware.

Implementation of the third mode (AC input detection) by the metering circuitry 212 (Figure 19) may occur in firmware to also allow AC input detection functionality to be enabled without compromising the speed at which the digital input/output module 310 can detect signals in the first ("Pulse") mode or the second ("KYZ") mode. Alternatively, the AC input signals may be processed within the digital input/output module 310. However, implementation of processing of the AC input signals in the digital input/output module 310, may use an RC-filter to convert the AC waveform into a DC signal that can be read by the metering circuitry 212, which may limit the pulse rate that can be resolved in first ("Pulse") mode and/or the second ("KYZ") mode.

Firmware implementation of the AC input processing in the third mode may also allow flexibility in adjusting a frequency range to be sensed by the metering circuitry 212 by simply changing the code within the firmware. In one example, the frequency range of sensing may be set to a predetermined range of about 5Hz to about 210Hz. Adjustment of the frequency range may be implemented with a firmware upgrade, or the frequency may be a user selectable parameter when the meter 100 is operational in the field. Alternatively, if AC input processing occurs with hardware within the digital input/output module 310, a low-end frequency limit may be set.

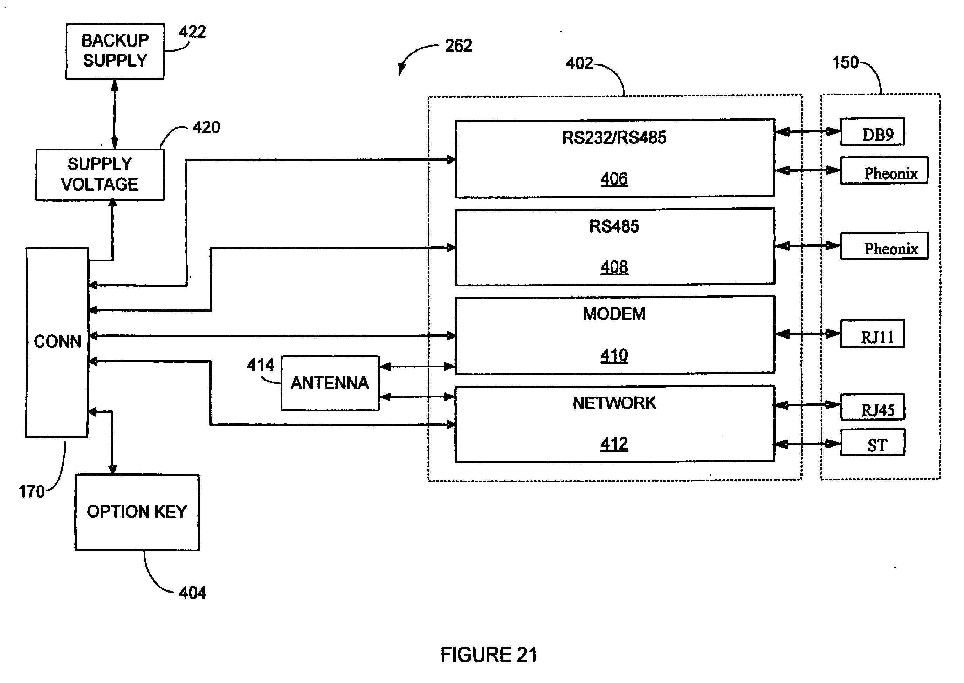

The communications module 262 may provide expanded/additional functionality related to communication with other devices external to the meter 100. Figure 21 is a block diagram illustrating the functionality of an example communications module 262 that includes a communication interface module 402 and an option key module 404. The example communication interface module 402 includes a first interface that is a first serial interface, such as an RS232/RS485 interface 406, a second interface that is a second serial interface, such as a RS485 interface 408, a third interface that is a modem interface 410, and fourth interface that is a network interface 412. In other examples, fewer or additional interfaces, such as proprietary interfaces, may be included in the communication interface module 402.

The first and second serial interfaces 402 and 404 may each include an RS 485 communication interface. The modem interface 406 may be any communications device that converts a signal from one form to another form that is suitable for transmission over communication circuits, such as, from digital to analog and then from analog to digital signals. The modem interface 406 may be a wired or a wireless device that uses an antenna 314. The antenna 314 may be included in the communications module 262, or may be externally coupled with the metering options module 114 via the I/O ports 150. The network interface 412 may be a wired or wireless interface to any form of LAN, WAN, etc. form of network. For wireless communication, the network interface 412 may use the antenna 414. The network interface 412 may include Ethernet communications, GPS time sync communication capabilities, wireless devices communications (e.g., 802.11 and the like), wireless mesh networks, Zigbee, Wi-Fi, and/or any other network communication standard and/or protocol. The Ethernet communications may be 10BaseT Ethernet, 10BaseFL Ethernet and/or any other Ethernet protocol. In addition, the network interface 412 may support proprietary protocols.

Each of the interfaces 406-412 may establish independent or separate communications with a device external to the meter 100. Thus, the metering options module may enable multiple instances of communications with the meter 100. The I/O ports 150 may be internally coupled directly or indirectly through electrical, electronic and/or optical components and/or hardware, software, and firmware components included in the communication interface module 402 to the electrical connector 170. As previously described, the electrical connector 170 may be coupled to the meter housing electrical connector 130 on the meter 100 when the metering options module 114 is installed on the meter 100. Accordingly, the metering circuitry 212 (Figure 19) may be enabled to communicate with external devices through the I/O ports 150 when the metering options module is installed on the meter 100.

Within the communication module 262, the I/O ports 150 may be communication ports that include optical communications ports (ST) that enable coupling and external communication using optical fiber, RJ11 (such as for modem communication) and RJ45 jacks (such as for Ethernet communication), Phoenix connectors (such as for RS485 communication), DB9 connectors (such as for RS232 communication), RCA jacks, and/or any other type of communication connector hardware. The electronic and/or optical components of the interface module 402 coupled with the I/O ports 150 may include, switches, gates, processor, CPU's, application specific integrated circuits (ASIC's), controllers, diodes, capacitors, inductors, resistors, bridges and other electronic and electrical devices used in communications circuits.

Referring to Figures 19 and 21, the metering circuitry 212 also may be configured to assign a communications protocol to an I/O port 150 in the metering options module 114 independent of the type of hardware connector included with the port, and independent of the communications protocol assigned to other communications ports 150. For example, the meter 100 may be configured to have first and second I/O ports 150 included in the metering options module 114 assigned to communicate with other devices. Each of the first and second I/O ports 150 may communicate independently of the other, and each may use a device language message specification (DLMS) protocol. In another example, each I/O port 150 may be assigned a different communications protocol. For example, a first communication port may be assigned to communicate with other devices using DLMS, a second communication port may be assigned to communicate using Modbus^{®} and a third communication port may be assigned to communicate with a device using ION^{®} communications protocol.

The communications protocol may be assigned to a communication port, or a communication port may be assigned to a communications protocol. Assignment may be performed by selecting an appropriate setting(s) on the options menu presented on the display 118, by factory settings, and/or by a controller in communication with the meter 100. An I/O port 150 also may be configured to communicate using two or more communications protocols substantially simultaneously. That is, for example, two communication protocols may co-exist at the same communication port 150. The communications protocols for the communication ports 150 may be changed, modified, updated and/or reprogrammed.

The communication capabilities available to the metering circuitry 212 included in the meter 100 from the metering options module 114 may be almost unlimited. The metering options module 114 may be configured to provide an Ethernet communications for the rack-mounted meter 100. The Ethernet communications may include 10BaseT and/or 10BaseFL. The rack mounted meter 100 may also be configured to communicate over an open, distributed communications network with a web server or other devices on the network. The meter 100, using the communications module 262, also may be configured to provide web server functions or functionality to serve other devices on the network. The communication module 262 may also provide for communication functionality using optical fiber, multiple serial ports and/or any combination thereof. Any combination of hardware related to communications is possible within the communication module 262. The communication module 262 also may be configured to provide a SCADA polling system.

The interface module 402 may be coupled with the metering circuitry 212 via the electrical connector 170. Alternatively, or in addition, the interface module 402 may wirelessly communicate with the metering circuitry 212. The power supply 244 may provide power to a supply voltage 420 via the electrical connector 170. The supply voltage 420 may provide power to the interface module 402, the I/O ports 150 and/or any other power consuming device in the communication module 262. In addition, the supply voltage 420 may supply power to a backup power supply 422 included in the metering options module 114. The backup power supply 422 may supply power to the meter 100 and/or the metering options module 114 in the event of degradation and/or loss of supply voltage 420, as similarly discussed with reference to the backup power supply 316 of Figure 20. The option key 404 may provide an indication to the metering circuitry 212 that the communication module 262 is present. In addition, the option key 404 may define the signals to be expected on the I/O ports 150.

The protective relay module 264 may be any form of hardware, circuitry, software and/or firmware capable of providing protection for at least a portion of the meter 100. For example, the protective relay module 264 may provide fusing or other circuit interrupting capability for at least portions of the meter 100. One or more analog signals may be routed through the protective relay module 264 to protect the meter 100. Since the metering options module is readily removable, without disturbing any tamper-proof seals on the meter 100, the protective relay module 264 may be readily replaced if an event causes the protective relay functionality, such as a fuse functionality, to occur.

In addition, or alternatively, the protective relay module 264 may include power quality event tracking capability. For example, the protective relay module 264 may be equipped with functionality that interrupts potentially damaging signals from reaching the metering circuitry 212, while continuing to record the event and/or disturbance that created the signals. In this scenario, the protective relay module 264 may include more robust circuitry and hardware capable of withstanding such an event without damage. Alternatively, the protective relay module 264 may include functionality to capture events from start to finish that otherwise interrupt the receipt and processing of electrical parameters by the metering circuitry 212, such as when an event causes damage to the metering circuitry 212. Signals with potential for such events may be routed through the protective relay module 264, or be provided as a parallel feed to the protective relay module 264.

The access key module 266 may enable additional functionality already present in the metering circuitry 212 by providing some form of authorization. The authorization may be hardware and/or software based. Enabling functionality may include for example, additional power parameter processing or power quality analysis functionality. Other examples include increased sample rates, improved hardware functionality, enhanced user interface, such as additional buttons and/or controls, improved/expanded graphics capability, and/or any other operational functionality within a meter 100 that is determined to be an optional feature.

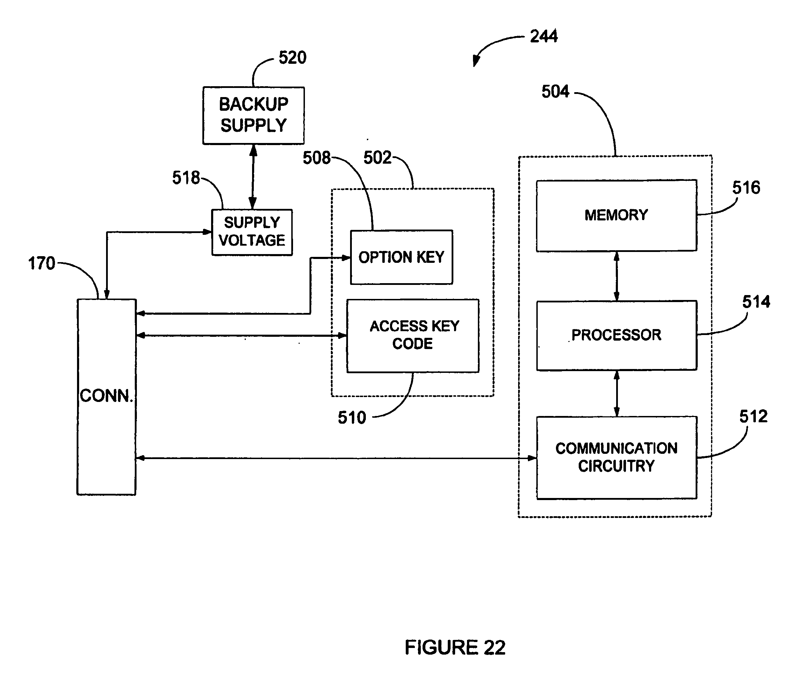

Figure 22 is a block diagram of an example access key module 266 that includes a hardware authorization 502 and a software authorization 504. The access key module 266 may also include a supply voltage 518 being supplied power from the power supply 244 (Figure 19) via the electrical connector 170. The supply voltage 518 may provide power to the access key module 266 and/or the metering options module 114. In addition, the supply voltage 518 may supply power to a backup power supply 520 included in the metering options module 114. The backup power supply 520 may supply power to the meter 100 and/or the metering options module 114 in the event of degradation or loss of the supply power 518, similar to the backup power supply 316 discussed with reference to Figure 20.

The hardware authorization 502 may represent a first layer of authorization that includes an option key 508, and an access key code 510. The option key 508 may be coupled with the metering circuitry 212 via the electrical connector 170 to indicate that the access key module 266 is present. In addition, the option key 508 may provide configuration information, authorization functionality in the access key module 266 to be verified, or any other information related to authorization of the additional functionality. The access key module 266 may be dip switches, resistors, and/or any other hardware based keying functionality.

The software authorization 504 may represent a second layer of authorization that can include a communication circuitry 512, a processor 514 and a memory 516. The communication circuitry 512 may be a UART, a buffer or any other device or mechanism for enabling communication between the processor 514 and the metering circuitry 212 (Figure 19). In another example, direct communication between the processor 514 and the metering circuitry 212 (Figure 19) may be possible, and the communication circuitry 512 may be omitted. The processor 514 may direct communication with the metering circuitry 212 and also access to the memory 516. The processor 514 may include firmware that contains an access key code that is provided to the metering circuitry 212 upon installation of the metering option module. The access key code may unpack, enable, and/or otherwise turn on additional features and/or functionality in the meter 100.

The processor 514 may also have the capability to track and maintain a database of meters 100 upon which the access key module 266 has been installed to activate additional functionality. For example, the processor 514 may provide a predetermined number of functionality activations, and function as a counter to track the number of activations by storing them in the memory 516. Alternatively, or in addition, the processor 514 may perform verification that the previously non-activated portion of the software of the metering circuitry 212 is an up to date version and update accordingly. The memory 516 may also include upgrade software that is downloadable to the metering circuitry 212 by the processor 514 to upgrade the base functionality of the meter 100. In other examples, either the hardware authorization 502 or the software authorization 504 may be separately implemented in a stand alone capacity to provide authorization and verification of the mounting and use of the metering options module 114 on the meter 100.

In another example, the memory 516 may include software to affect the changed functionality of the metering circuitry 212. Thus, when the metering options module 414 is installed, the processor 514 may download the software into the metering circuitry 212. In still other examples, the memory 516 could include patches, fixes and revisions to the existing base functionality included in the metering circuitry 212. The revisions could be downloaded by the processor 514 when the metering options module is installed. Alternatively, the revisions/updates/improvements could be maintained in the memory 516 and executed by the metering circuitry directly from the memory 516.

The functionality of the previously described modules 260-266, as well as any other functionality, may be mixed or otherwise combined in the metering options module 414. In addition, the metering options module 414 may provide standalone functionality, such as monitoring the operation of the metering circuitry 212 and providing an indication when an error or fault occurs within the metering circuitry 212.

Referring again to Figures 15-18, the electrical connector 170 on a surface of the metering options module 114 may engage with the connector 130 on a surface of the meter house 102 to change the operational functionality, such as the I/O functionality and/or the communications functionality, of the meter 100. A housing 182 of the metering options module 114 may be a substantially rectangular box, or rectangular parallelepiped that is dimensioned to fit within the shelf dimensions or dimensional envelop of the meter 100, and/or allow the meter 100 to fit within a bay of an equipment rack when the metering options module 114 is coupled thereto.

The metering options module 114 may include one or more flanges 184. The flange 184 may be fixedly coupled and/or form a part of the housing 182. In the example metering option module 114 illustrated in Figures 14-18, the housing 182 includes a first surface 186 and a second surface 188 that is opposite the first surface 186. The first surface 186 may be positioned to be substantially flush with the first portion 108a of the two tiered surface 108 (Figure 1) when the metering options module 114 is coupled with the meter 100. The second surface 188 may be contiguous with the second portion 108b of the two-tiered surface 108 (Figure 1) when the metering options module 114 is coupled with the meter 100.

The flange 184 may be positioned substantially parallel with the second surface 188, and substantially perpendicular with the second connector panel 106b (Figure 4) of the meter housing 102. The flange 184 may be formed to include at least one aperture 190. The apertures 190 may be aligned with the fastener 117 on the meter housing 102 (Figure 2) when the metering option module 114 is mounted on the meter house 102. The flange 184 may also include one or more tabs 124. The tab(s) 124 may be formed to be substantially perpendicular to the flange 184 and substantially parallel to a surface of the meter housing 102, such as the second connector panel 106b (Figure 4). Accordingly, when the metering options module 114 is installed on the surface of the metering housing 102 (Figure 4), the tab 124 may contiguously align with a portion of the second connector panel 106b (Figure 4).

The tab 124 may include a coupling aperture 194. The coupling aperture 194 may be alignable with the ground lug 126 (Figure 4) on the meter housing 102 when the metering options module 114 is coupled with the meter housing 102. The metering options module 114 may also include at least one alignment aperture 196. The alignment apertures 196 may be formed to accommodate the alignment pins 131 on the first connector panel 106a (Figure 5) when the metering options module 114 is coupled with the meter housing 102.

The metering options module 114 may be grounded via the ground lug 126 as previously described. The metering options module 114 may also include a lug, a lance, a cleat, or some other feature to be used in conjunction with a tamper-proof seal to couple the metering options module 114 to the meter 100. The housing 182 of the metering options module 114 may also be separately sealable with a tamper proof seal, such as a revenue or verification seal that is separate from the tamper proof seal, such as a verification seal, of the meter 100.

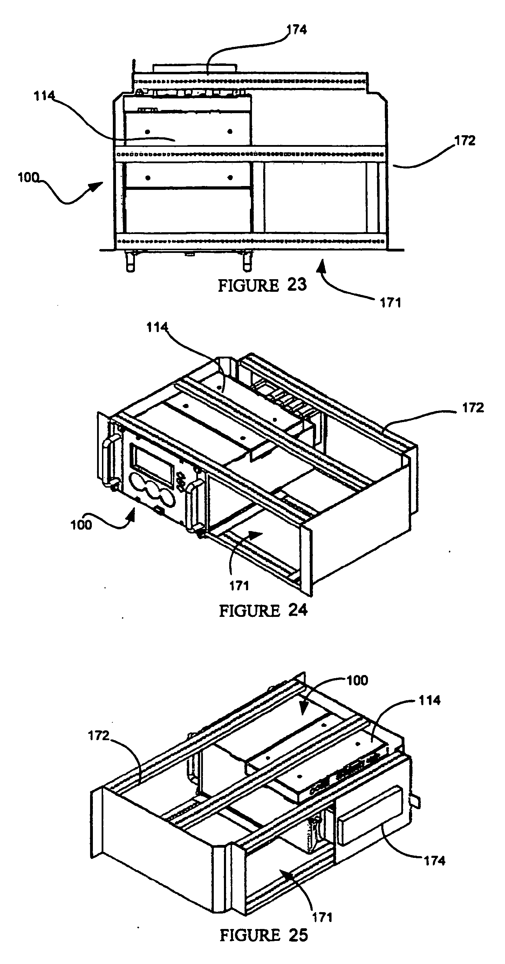

Figure 23 illustrates a top view of an example meter 100 mounted in a bay 171 of an equipment rack assembly 172. Figure 24 illustrates a perspective front view of an example of the meter 100 mounted in the bay 171 of the equipment rack assembly 172. Figure 25 illustrates a perspective rear view of an example of the meter 100 mounted in the bay 171 of the equipment rack assembly 172. In Figures 23-25, the equipment rack assembly 172 may be a 48.3 cm equipment rack designed in accordance with the requirements set forth by DIN 43862. The meter 100 with the metering options module 114 affixed thereto may fit within the dimensions of a standard 48.3 cm equipment rack. The meter 100 may plug into a bay electrical connector 174, such as an Essailec connector, located in a determined position, such as at the back of the equipment rack assembly 172. The meter 100 may be mounted to the rack assembly 172, with or without the metering options module 114.

The meter 100 may be easily or readily removed or mounted to the equipment rack assembly 172. When inserted, the rack electrical connector 128 on the second connector panel 106b of the meter 100 (Figure 6) may engage the bay electrical connector 174 in the rack assembly 172. When the connectors 128 and 174 are engaged, the meter 100 may be powered by one of the connections, and receive signals to allow the meter 100 to perform revenue metering as well as power quality monitoring for an electrical circuit, such as multi-phase high voltage power supplied over a conductor to a dynamic load circuit.

The metering circuitry included in the meter 100 may log a time that the meter 100 is installed in the equipment rack assembly 172, as well as a time that the meter 100 is removed from the equipment rack assembly 172. The log may be accessed using the user interface of the control panel 116 (Figure 3) of the meter 100, and/or through one of the communications ports, such as a communication port 150 (Figure 14) provided by the metering options module 114. The metering circuitry may be configured to detect whether the meter 100 is installed in the equipment rack 172 using an analog or digital I/O connection for the meter 100. When connection or disconnection of any of the I/O between the meter 100 and the equipment rack 172 is detected, the corresponding event may be time stamped and stored in memory in an event log.

The metering circuitry of the meter 100 also may determine whether removal of the meter 100 is appropriate and set an alarm or indicator when an attempt to remove the meter 100 from the rack assembly 172 is made when removal is inappropriate. For example, the metering circuitry may detect that the meter 100 is being removed, such as due to a disengagement/disconnection of the rack connector 128 and the bay connector 174. In response to the detection, the meter 100 may automatically set a visual and/or audible alarm(s) indicating that disengagement/disconnection is inappropriate. The meter 100 also may include a mechanical interlock that actuates to latch or engage the rack assembly 172 after the meter 100 is installed in the bay 171. The interlock may be released only when the meter 100 is in a state in which the meter 100 may be removed, as determined by the metering circuitry based on the I/O received by the meter 100.

In one example configuration, a secondary electrical connector (not shown), also or alternatively, may be used on the equipment rack assembly 172. The secondary connector may be configured to be positioned between the bay connector 174 and the rack electrical connector 128. Alternatively, the secondary connector may be used in place of the bay connector 172 or the rack electrical connector 128. The secondary connector may provide a make-before-break functionality to short those inputs that should be shorted, such as current transformer (CT) inputs, and open those inputs that should be opened, such as potential transformer (PT) inputs. Accordingly, with the secondary connector, the rack-mounted meter 100 may be removed and installed in the bay 171 while the conductor the meter 100 is monitoring is live or under power. The secondary connector may operate in reverse when the meter 100 is installed in the bay 171.

The metering circuitry of the meter 100 also may be configured to approximate power usage during a reset of the meter 100, such as after a power failure. Since the meter 100 includes a clock, the meter 100 may determine when the meter 100 last read energy usage and how long the meter 100 may have been de-energized. For example, if the meter 100 is removed from the equipment rack 172, or is otherwise de-energized or removed from service, the meter 100 can record the event. When the meter 100 is reset and powered back up, the metering circuitry can compare the time that the meter 100 last measure power parameters to the present time to calculate an amount of time that the meter 100 was powered down or otherwise out of service. The metering circuitry can also review power usage before it was taken out of service to interpolate or approximate an amount of power usage while the meter 100 was out of service. The metering circuitry may also record the approximation of the amount of power usage, and mark or flag the event for future review.

The configuration of the rack-mounted meter 100 with the externally mounted metering options module 114 provides a capability to incorporate features and functionality of the meter 100 in a separable module having its own housing. The metering options module 114 may be field replaceable without disturbing a tamper proof seal, such as a verification or utility seal included on the meter 100. The replaceable metering options module 114 may provide additional communications functionality and connections, input/output functionality and connections, and/or any other functionality and connections for the meter 100. Communications connectors and/or input/output connectors may be directly included on the housing of the metering options module 114, rather than on the connector panel of the meter 100. As communications or other input/output needs change, the metering options module 114 may be changed or replaced accordingly, without requiring modification to the meter 100 and/or disturbance of the tamper proof seals.

The metering options module 114 that is removably installed flush with the first portion 108a of the two-tiered surface 108 of the meter 100 enables changing of the functionality of the meter 100 without disturbing the seal on the meter 100. The metering options module 114 may be mounted outside the meter housing 102 and may be changed without having to modify or open the meter 100. Without the metering options module 114, a field retrofit of the communication or input/output connectors may not be possible, especially if tamper-proof seals were disturbed. Therefore, a meter configuration having a separable metering options module 114 offers great flexibility in providing various alternatives in future designs, without requiring a redesign or complicated retrofitting of the meter 100. The metering options module 114 may be used to expand operation of the meter for options other than communication or input/outputs. For example, the metering options module 114 may be changed out to change or provide additional calculated power parameters, perform additional power quality monitoring, etc.

When racked into the bay 171 of the equipment rack assembly 172, the rack-mounted meter 100 may receive power for operating as well as signals corresponding to electrical parameters of one or more conductors feeding a circuit or load that is to be monitored. In one example, the metering circuitry included in the rack-mounted meter 100 may be configured to measure and/or approximate a voltage that may appear on a grounded line by a comparison of reference voltage V_{ref} that is connected to a neutral line of the circuit or load being monitored with an internal dc voltage. Ordinarily the reference voltage V_{ref} should be OV. However, the reference voltage V_{ref} may vary in different places in a building. The reference voltage V_{ref} may vary with current and resistance in the neutral line. The reference voltage V_{ref} can also indicate 3^{rd} harmonics, power surges, problems with the power system, possible wiring problems, and the like. In one example, a ground voltage V_{G} may be calculated, by comparing the reference voltage V_{ref} to an internal dc reference voltage V_{bias} that is referenced to earth ground. The internal dc reference voltage V_{bias} may be supplied by a constant voltage supply. Fluctuations in the ground voltage to neutral may be determined from V_{bias}. An existing spare or unused op-amp included in the metering circuitry of the meter 100 can be biased with a resistor circuit to provide the reference voltage V_{ref} at an output based on the comparison to the V_{bias} voltage. Using the spare op-amp utilizes existing circuitry and reduces a number of terminals or inputs to the meter.

The input signals provided to the rack-mounted meter 100 may be scaled based on the strength of the signal. The signals from the equipment rack assembly 172 often vary over a wide range of voltages. The metering circuitry included in the meter 100 may detect the strength of the input signal(s) and process the signals through a multi-gain stage circuit before the signals are further processed. The metering circuitry included in the meter 100 may be configured to monitor the amplitude of an input signal. Based on the amplitude, the metering circuitry may adjust the gain of the input signal to provide an input signal for the meter 100 having an appropriate signal to noise ratio. The metering circuitry may select an appropriate scaling based on the amplitude of the input signal. Accordingly, the meter 100 may be used over a wide dynamic range of input signals.

When the signals are received, the metering circuitry may sample the signal to provide a sampled or digital equivalent signal representing the analog signal. The signals may be sampled at a sampling frequency that is determined based on the analog frequency of the input signal. That is, the rack-mounted meter 100 has a sampling clock that may be adjusted according to the frequency of the power system being monitored.

The sampled signal is processed using metering circuitry that includes a controller, a logic unit, a processor, an ASIC and/or combinations thereof configured to determine electrical parameters of the circuit based on the sampled signals. The sampled signals may be processed according to Fast Fourier Data Processing techniques. The use of Fourier transforms to process the signals solves issues of high computational intensity due to continuous harmonic analysis on the sampled input signals. The input signals may be continuously sampled and averaged with the metering circuitry. The averaged signals may be converted or transformed to the Frequency domain with the metering circuitry. A frequency average may be determined by averaging in the time domain and transforming the average once. The Fast Fourier data processing technique translates/manipulates the data to Radix 2 numbers to process the data using Fourier transforms.

The meter 100 may display compliance of a monitored conductor to multiple power quality standards. The compliance may be displayed on the screen 118, and updated as service complies or fails to comply with a power quality standard. Examples of a power quality standard to which compliance may be displayed include EN5160, IEC 61000 -4-30. The compliance display may be updated in real time.

Various embodiments of a rack-mounted power meter having an externally mounted removable metering options module have been described and illustrated. However, the description and illustrations are by way of example only. Many more embodiments and implementations are possible within the scope of this invention and will be apparent to those of ordinary skill in the art. The various embodiments are not limited to the described environments, and can be applied to a wide variety of activities.

## Claims

1. A power meter (100) configured to measure electrical parameters of electrical energy present in a conductor, the power meter comprising:
a meter housing (102);
a metering options module (114) configured to be removably mounted on an externally accessible surface of the meter housing, wherein the meter options module comprises a first electrical connector (170), and wherein the meter housing comprises a second electrical connector (130), and wherein the first electrical connector is configured to be engaged with the second electrical connector only when the metering options module is removably mounted on the meter housing.
**characterized in that**
the meter housing is configured to be rack mounted in a bay (171) of an equipment rack (172); and
the metering options module is mounted on the surface of the meter housing so as to be within the dimensions of the bay.

2. The power meter of claim 1, wherein the meter housing comprises metering circuitry (162) and a first rack electrical connector (128) positioned on a surface of the meter housing to engage a second rack electrical connector positioned in the equipment rack when the meter housing is mounted in the bay, the metering circuitry disposed in the meter housing and configured to receive one or more electrical parameters via the first rack electrical connector, the metering circuitry being operable to measure and process the one or more electrical parameters.

3. The power meter of claim 2, wherein the meter housing comprises a tamper proof seal coupled with the meter housing and configured to indicate the occurrence of access to at least one of the meter housing or the metering circuitry, or a combination thereof.

4. The power meter of claim 2 or 3, wherein the metering options module is configured to change the functionality of the metering circuitry.

5. The power meter as in any of claims 2-4, wherein the metering options module is configured with functionality that is removably combinable with functionality present in metering circuitry.

6. The power meter as in any of claims 2-5, wherein the metering options module is configured with access key functionality, the access key functionality operable to enable pre existing functionality present in the metering circuitry.

7. The power meter of an of claims 2-6, further comprising a bus operable to couple the second electrical connector with the metering circuitry.

8. The power meter of claim 7, wherein the bus is a printed circuit board that is coupled with an edge connector (164) included in the metering circuitry.

9. The power meter of any of claims 1-8, wherein the meter housing comprises a processor (230) disposed in the meter housing and operable to process measured electrical parameters to perform revenue metering and power quality metering, and a tamper proof seal coupled with an external surface of the meter housing and positioned to indicate the occurrence of access to the meter housing, wherein the metering options module is mountable on the meter housing without disturbance of the tamper proof seal, to change the functionality of the processor.

10. The power meter of claim 9, wherein the metering options module includes at least one of a hardware authorization or a software authorization each configured to enable additional functionality already existing, but previously disabled, in the processor when sensed by the processor.

11. The power meter of claim 9 or 10, wherein the metering options module includes an option key (306), the option key readable by the processor to indicate to the processor the functionality change providable by the removable options module.

12. The power meter as in any of claims 9-11, wherein the metering options module includes an input/output module (260) configured to increase the input/output capability of the processor.

13. The power meter as in any of claims 9-12, wherein the metering options module includes a communications module (262) configured to increase the communication functionality of the processor.

14. The power meter as in any of claims 1-13, further comprising a flange (184) coupled with the metering options module, wherein the flange is configured to fixedly couple the metering options module to the surface of the meter housing.

15. The power meter as in claims 1-14, wherein the metering options module further comprises an options rack electrical connector (150) positioned on a surface of the metering options module, wherein the options rack electrical connector is positioned to engage an options rack electrical connector positioned in an equipment rack when the metering housing, with the metering options module removably coupled thereto is positioned in the bay of the equipment rack.

16. The power meter as in any of claims 1-15, wherein the metering options module further comprises a communications connector positioned on a surface of the metering options module.

17. The power meter as in any of claims 1-16, wherein the metering options module further comprises an input/output connector positioned on a surface of the metering options module.

18. The power meter as in any of claims 1-17, wherein the metering options module is configured with protective relay functionality.

19. The power meter as in any of claims 1-18, wherein the metering options module is formed to include alignment apertures, the alignment apertures are configured to engage corresponding alignment pins included on the meter housing.

20. The power meter as in any of claims 1-19, wherein the first electrical connector is mounted on an external surface of the metering options module, and the second electrical connector is mounted on an external surface of the meter housing.

21. The power meter of claim 20, wherein an external surface of the meter housing is positioned proximate an external surface of the metering options module so that the first electrical connector and the second electrical connector engage when the metering options module is removably mounted on the meter housing.

22. The power meter as in any of claims 1-21, further comprising a tamper proof seal coupled with the meter housing and configured to indicate when the meter housing has been opened, wherein the metering options module is removably mountable on the meter housing without disturbance of the tamper proof seal.

23. The power meter as in any of claims 1-22, wherein an externally accessible surface of the meter housing comprises a first portion and a second portion, the first portion formed as a slot to accommodate the metering options module.

24. The power meter of claim 23, wherein the metering options module is positionable in the slot to extend outwardly no further than about flush with an outermost external dimension of an externally accessible surface of the meter housing.

25. The power meter as in claim 23 or 24, wherein the first portion is recessed with respect to the second portion, and a first planar surface of the metering options module is substantially contiguously aligned with a planar surface of the first portion when the metering options module is mounted, and a second planar surface of the metering options module is in substantially the same plane with a planar surface of the second portion of the meter housing.

26. The power meter as in any of claims 23-25, further comprising a removable cover (181) formed to cover an opening to the slot.

27. The power meter as in any of claims 1-26, wherein the metering option module comprises a tab (124) configured to be coupled with the meter housing, wherein a ground lug included on the meter housing is configured to ground the metering options module and fixedly mount the metering options module on the meter housing via the tab.

28. The power meter as in any of claims 1-27, wherein the metering options module comprises a flange configured to be substantially contiguous with the meter housing when the metering options module is mounted on the meter housing, the flange further configured to be coupled with the meter housing by a fastener.

29. The power meter as in any of claims 1-28, wherein the second electrical connector operable to supply power to the metering options only when the metering options module is mounted on the metering housing.

## Patentansprüche

1. Leistungsmessgerät (100), das dazu eingerichtet ist, elektrische Parameter elektrischer Energie zu messen, die in einem Leiter vorhanden ist, wobei das Leistungsmessgerät umfasst:
ein Messgerätgehäuse (102);
ein Messoptionsmodul (114), das dazu eingerichtet ist, lösbar an einer von außen zugänglichen Oberfläche des Messgerätegehäuses angebracht zu werden, wobei das Messoptionsmodul einen ersten elektrischen Verbinder (170) umfasst, das Messgerätegehäuse einen zweiten elektrischen Verbinder (130) umfasst und der erste elektrische Verbinder dazu eingerichtet ist, mit dem zweiten elektrischen Verbinder nur dann in Eingriff gebracht zu werden, wenn das Messoptionsmodul lösbar an dem Messgerätegehäuse angebracht ist,
**dadurch gekennzeichnet, dass**
das Messgerätegehäuse dazu eingerichtet ist, in einem Schacht (171) eines Geräteregals (172) regalartig aufgenommen zu werden; und
das Messoptionsmodul auf der Oberfläche des Messgerätegehäuses derart angebracht ist, dass es sich innerhalb der Abmessungen des Schachtes befindet.

2. Leistungsmessgerät nach Anspruch 1, bei dem das Messgerätegehäuse einen Messschaltkreis (162) und einen ersten elektrischen Regalverbinder (128) umfasst, der auf einer Oberfläche des Messgerätegehäuses derart angebracht ist, dass er mit einem zweiten elektrischen Regalverbinder, der in dem Geräteregal angebracht ist, in Eingriff gelangt, wenn das Messgerätegehäuse in dem Schacht aufgenommen wird, der Messschaltkreis in dem Messgerätegehäuse angeordnet und dazu eingerichtet ist, wenigstens einen elektrischen Parameter über den ersten elektrischen Regalverbinder zu empfangen, und der Messschaltkreis so betätigt werden kann, dass er den wenigstens einen elektrischen Parameter misst und verarbeitet.

3. Leistungsmessgerät nach Anspruch 2, bei dem das Messgerätegehäuse ein manipulationssicheres Siegel umfasst, das mit dem Messgerätegehäuse verbunden und dazu eingerichtet ist, den erfolgten Zugriff auf das Messgerätegehäuse und/oder den Messschaltkreis oder eine Kombination aus diesen anzuzeigen.

4. Leistungsmessgerät nach Anspruch 2 oder 3, bei dem das Messoptionsmodul dazu eingerichtet ist, die Funktionalität des Messschaltkreises zu ändern.

5. Leistungsmessgerät nach einem der Ansprüche 2 bis 4, bei dem das Messoptionsmodul mit einer Funktionalität ausgestattet ist, die mit einer Funktionalität, die in dem Messschaltkreis vorhanden ist, trennbar kombiniert werden kann.

6. Leistungsmessgerät nach einem der Ansprüche 2 bis 5, bei dem das Messoptionsmodul mit einer Zugriffsschlüsselfunktionalität ausgestattet ist, wobei die Zugriffsschlüsselfunktionalität derart betätigt werden kann, dass sie eine bereits existierende Funktionalität in Kraft setzen kann, die in dem Messschaltkreis vorhanden ist.

7. Leistungsmessgerät nach einem der Ansprüche 2 bis 6, weiterhin umfassend einen Bus, der so betätigt werden kann, dass er den zweiten elektrischen Verbinder mit dem Messschaltkreis verbindet.

8. Leistungsmessgerät nach Anspruch 7, bei dem der Bus eine Leiterplatte ist, die mit einem Steckverbinder (164) verbunden ist, der in dem Messschaltkreis enthalten ist.

9. Leistungsmessgerät nach einem der Ansprüche 1 bis 8, bei dem das Messgerätegehäuse einen Prozessor (230) umfasst, der in dem Messgerätegehäuse angebracht ist und so betätigt werden kann, dass er gemessene elektrische Parameter verarbeitet, um Ertragsmessungen und Leistungsqualitätsmessungen auszuführen, und ein manipulationssicheres Siegel umfasst, das mit einer Außenoberfläche des Messgerätegehäuses verbunden und so angebracht ist, dass es einen erfolgten Zugriff auf das Messgerätegehäuse kennzeichnet, wobei das Messoptionsmodul an dem Messgerätegehäuse ohne Zerstörung des manipulationssicheren Siegels angebracht werden kann, um die Funktionalität des Prozessors zu ändern.

10. Leistungsmessgerät nach Anspruch 9, bei dem das Messoptionsmodul eine Hardware-Autorisierung und/oder eine Software-Autorisierung umfasst, die jeweils derart konfiguriert ist, dass sie eine zusätzliche Funktionalität, die bereits vorhanden ist, jedoch zuvor deaktiviert wurde, in dem Prozessor in Kraft setzt, wenn sie von dem Prozessor erfasst wird.

11. Leistungsmessgerät nach Anspruch 9 oder 10, bei dem das Messoptionsmodul eine Wahltaste (306) umfasst, wobei die Wahltaste von dem Prozessor gelesen werden kann, um dem Prozessor den Funktionalitätswechsel zu signalisieren, der von dem lösbaren Optionsmodul bereitgestellt werden kann.

12. Leistungsmessgerät nach einem der Ansprüche 9 bis 11, bei dem das Messoptionsmodul ein Eingangs-/Ausgangsmodul (260) umfasst, das dazu eingerichtet ist, die Eingangs-/Ausgangsleistungsfähigkeit des Prozessors zu erhöhen.

13. Leistungsmessgerät nach einem der Ansprüche 9 bis 12, bei dem das Messoptionsmodul ein Kommunikationsmodul (262) umfasst, das dazu eingerichtet ist, die Kommunikationsfunktionalität des Prozessors zu erhöhen.

14. Leistungsmessgerät nach einem der Ansprüche 1 bis 13, weiterhin umfassend einen Flansch (184), der mit dem Messoptionsmodul verbunden ist, wobei der Flansch dazu eingerichtet ist, das Messoptionsmodul mit der Oberfläche des Messgerätegehäuses fest zu verbinden.

15. Leistungsmessgerät nach Anspruch 1 bis 14, bei dem das Messoptionsmodul weiterhin einen elektrischen Regaloptionsverbinder (150) umfasst, der auf einer Oberfläche des Messoptionsmoduls angeordnet ist, wobei der elektrische Regaloptionsverbinder so angeordnet ist, dass er mit einem elektrischen Regaloptionsverbinder, der in dem Geräteregal angebracht ist, in Eingriff steht, wenn das Messgerätegehäuse mit dem lösbar angeschlossenen Messoptionsmodul in dem Schacht des Geräteregals angeordnet ist.

16. Leistungsmessgerät nach einem der Ansprüche 1 bis 15, bei dem das Messoptionsmodul weiterhin einen Kommunikationsverbinder umfasst, der auf einer Oberfläche des Messoptionsmoduls angebracht ist.

17. Leistungsmessgerät nach einem der Ansprüche 1 bis 16, bei dem das Messoptionsmodul weiterhin einen Eingangs-/Ausgangsverbinder umfasst, der auf einer Oberfläche des Messoptionsmoduls angeordnet ist.

18. Leistungsmessgerät nach einem der Ansprüche 1 bis 17, bei dem das Messoptionsmodul mit einer Schutzrelaisfunktion ausgestattet ist.

19. Leistungsmessgerät nach einem der Ansprüche 1 bis 18, bei dem das Messoptionsmodul derart ausgebildet ist, dass es Ausrichtöffnungen umfasst, wobei die Ausrichtöffnungen dazu eingerichtet sind, mit entsprechenden Ausrichtzapfen in Eingriff zu gelangen, die in dem Messgerätegehäuse enthalten sind.

20. Leistungsmessgerät nach einem der Ansprüche 1 bis 19, bei dem der erste elektrische Verbinder an einer Außenfläche des Messoptionsmoduls angebracht ist und der zweite elektrische Verbinder an einer Außenfläche des Messgerätegehäuses angebracht ist.

21. Leistungsmessgerät nach Anspruch 20, bei dem eine Außenfläche des Messgerätegehäuses in der Nähe einer Außenfläche des Messoptionsmoduls derart angebracht ist, dass der erste elektrische Verbinder und der zweite elektrische Verbinder in Eingriff stehen, wenn das Messoptionsmodul lösbar an dem Messgerätegehäuse angebracht ist.

22. Leistungsmessgerät nach einem der Ansprüche 1 bis 21, weiterhin ein manipulationssicheres Siegel umfassend, das mit dem Messgerätegehäuse verbunden und dazu eingerichtet ist anzuzeigen, wenn das Messgerätegehäuse geöffnet wurde, wobei das Messoptionsmodul an dem Messgerätegehäuse lösbar angebracht werden kann, ohne dass das manipulationssichere Siegel zerstört wird.

23. Leistungsmessgerät nach einem der Ansprüche 1 bis 22, bei dem eine von außen zugängliche Oberfläche des Messgerätegehäuses einen ersten Abschnitt und einen zweiten Abschnitt umfasst, wobei der erste Abschnitt als Schlitz ausgebildet ist, um das Messoptionsmodul aufzunehmen.

24. Leistungsmessgerät nach Anspruch 23, bei dem das Messoptionsmodul in dem Schlitz derart angeordnet werden kann, dass es nicht weiter nach außen hervorragt, so dass es mit einer äußersten Außenabmessung einer von außen zugänglichen Oberfläche des Messgerätegehäuses etwa bündig ist.

25. Leistungsmessgerät nach Anspruch 23 oder 24, bei dem der erste Abschnitt in Bezug auf den zweiten Abschnitt zurückgesetzt ist und eine erste ebene Oberfläche des Messoptionsmoduls im wesentlichen zusammen mit einer ebenen Oberfläche des ersten Abschnittes ausgerichtet ist, wenn das Messoptionsmodul angebracht ist, und sich eine zweite ebene Oberfläche des Messoptionsmoduls in im wesentlichen derselben Ebene mit einer ebenen Oberfläche des zweiten Abschnittes des Messgrätegehäuses befindet.

26. Leistungsmessgerät nach einem der Ansprüche 23 bis 25, weiterhin umfassend eine abnehmbare Abdeckung (181), die dazu ausgebildet ist, eine Öffnung in den Schlitz abzudecken.

27. Leistungsmessgerät nach einem der Ansprüche 1 bis 26, bei dem das Messoptionsmodul einen Vorsprung (124) umfasst, der dazu eingerichtet ist, mit dem Messgerätegehäuse gekoppelt zu werden, wobei eine Erdungsklemme, die Bestandteil des Messgerätegehäuses ist, dazu eingerichtet ist, das Messoptionsmodul zu erden und das Messoptionsmodul an dem Messgerätegehäuse über den Vorsprung fest anzubringen.

28. Leistungsmessgerät nach einem der Ansprüche 1 bis 27, bei dem das Messoptionsmodul einen Flansch umfasst, der derart beschaffen ist, dass er im wesentlichen mit dem Messgerätegehäuse zusammenhängt, wenn das Messoptionsmodul an dem Messgerätegehäuse angebracht ist, wobei der Flansch weiterhin dazu eingerichtet ist, mit dem Messgerätegehäuse durch eine Befestigungseinrichtung verbunden zu werden.

29. Leistungsmessgerät nach einem der Ansprüche 1 bis 28, bei dem der zweite elektrische Verbinder so betätigt werden kann, dass er dem Messoptionsmodul nur dann Strom zuführt, wenn das Messoptionsmodul in dem Messgerätegehäuse angebracht ist.

## Revendications

1. Compteur électrique (100) configuré pour mesurer des paramètres électriques d'une énergie électrique présente dans un conducteur, le compteur électrique comprenant :
un boîtier de compteur (102) ;
un module d'options de mesure (114) configuré pour être monté de manière amovible sur une surface accessible depuis l'extérieur du boîtier de compteur, dans lequel le module d'options de mesure comprend un premier connecteur électrique (170), dans lequel le boîtier de compteur comprend un deuxième connecteur électrique (130), et dans lequel le premier connecteur électrique est configuré pour s'engager avec le deuxième connecteur électrique uniquement quand le module d'options de mesure est monté de manière amovible sur le boîtier de compteur,
**caractérisé**
**en ce que** le boîtier de compteur est configuré pour être monté en rack dans une baie (171) d'un rack d'équipement (172) ; et
**en ce que** le module d'options de mesure est monté sur la surface du boîtier de compteur de manière à rester dans les dimensions de la baie.

2. Compteur électrique selon la revendication 1, dans lequel le boîtier de compteur comprend un circuit de mesure (162) et un premier connecteur électrique de rack (128) positionné sur une surface du boîtier de compteur pour s'engager avec un deuxième connecteur électrique de rack positionné dans le rack d'équipement lorsque le boîtier de compteur est monté dans la baie, le circuit de mesure étant agencé dans le boîtier de compteur et configuré pour recevoir un ou plusieurs paramètres électriques via le premier connecteur électrique de rack, le circuit de mesure étant utilisable pour mesurer et traiter lesdits un ou plusieurs paramètres électriques.

3. Compteur électrique selon la revendication 2, dans lequel le boîtier de compteur comprend un sceau de sécurité accouplé au boîtier de compteur et configuré pour indiquer une occurrence d'accès à au moins un élément parmi le boîtier de compteur et le circuit de mesure, ou à une combinaison desdits éléments.

4. Compteur électrique selon la revendication 2 ou 3, dans lequel le module d'options de mesure est configuré pour changer la fonctionnalité du circuit de mesure.

5. Compteur électrique selon l'une quelconque des revendications 2 à 4, dans lequel le module d'options de mesure est configuré avec une fonctionnalité qui peut être combinée de manière amovible avec une fonctionnalité présente dans le circuit de mesure.

6. Compteur électrique selon l'une quelconque des revendications 2 à 5, dans lequel le module d'options de mesure est configuré avec une fonctionnalité de clé d'accès, la fonctionnalité de clé d'accès étant utilisable pour activer une fonctionnalité préexistante présente dans le circuit de mesure.

7. Compteur électrique selon l'une quelconque des revendications 2 à 6, comprenant en outre un bus utilisable pour accoupler le deuxième connecteur électrique au circuit de mesure.

8. Compteur électrique selon la revendication 7, dans lequel le bus est un circuit imprimé qui est accouplé à un connecteur de bord (164) inclus dans le circuit de mesure.

9. Compteur électrique selon l'une quelconque des revendications 1 à 8, dans lequel le boîtier de compteur comprend un processeur (230) agencé dans le boîtier de compteur et utilisable pour traiter des paramètres électriques mesurés afin de mettre en oeuvre une mesure de revenu et une mesure de qualité d'alimentation, et un sceau de sécurité accouplé à une surface externe du boîtier de compteur et positionné pour indiquer l'occurrence d'un accès au boîtier de compteur, dans lequel le module d'options de mesure peut être monté sur le boîtier de compteur sans affecter le sceau de sécurité pour modifier la fonctionnalité du processeur.

10. Compteur électrique selon la revendication 9, dans lequel le module d'options de mesure comprend au moins une autorisation parmi une autorisation matérielle et une autorisation logicielle configurées chacune pour permettre au processeur une fonctionnalité additionnelle déjà existante, mais auparavant désactivée, lorsqu'elle est détectée par le processeur.

11. Compteur électrique selon la revendication 9 ou 10, dans lequel le module d'options de mesure comprend une clé optionnelle (306), la clé optionnelle pouvant être lue par le processeur pour indiquer au processeur le changement de fonctionnalité qui peut être fourni par le module d'options amovible.

12. Compteur électrique selon l'une quelconque des revendications 9 à 11, dans lequel le module d'options de mesure comprend un module d'entrée/sortie (260) configuré pour augmenter la capacité d'entrée/sortie du processeur.

13. Compteur électrique selon l'une quelconque des revendications 9 à 12, dans lequel le module d'options de mesure comprend un module de communication (262) configuré pour augmenter la fonctionnalité de communication du processeur.

14. Compteur électrique selon l'une quelconque des revendications 1 à 13, comprenant en outre une bride (184) accouplée au module d'options de mesure, dans lequel la bride est configurée pour accoupler de manière fixe le module d'options de mesure à la surface du boîtier de compteur.

15. Compteur électrique selon les revendications 1 à 14, dans lequel le module d'options de mesure comprend en outre un connecteur électrique de rack d'options (150) positionné sur une surface du module d'options de mesure, dans lequel le connecteur électrique de rack d'options est positionné pour s'engager avec un connecteur électrique de rack d'options positionné dans un rack d'équipement lorsque le boîtier de compteur, auquel le module d'options de mesure est accouplé de manière amovible, est positionné dans la baie du rack d'équipement.

16. Compteur électrique selon l'une quelconque des revendications 1 à 15, dans lequel le module d'options de mesure comprend en outre un connecteur de communication positionné sur une surface du module d'options de mesure.

17. Compteur électrique selon l'une quelconque des revendications 1 à 16, dans lequel le module d'options de mesure comprend en outre un connecteur d'entrée/sortie positionné sur une surface du module d'options de mesure.

18. Compteur électrique selon l'une quelconque des revendications 1 à 17, dans lequel le module d'options de mesure est configuré avec une fonctionnalité de relais de protection.

19. Compteur électrique selon l'une quelconque des revendications 1 à 18, dans lequel le module d'options de mesure est formé pour inclure des ouvertures d'alignement, les ouvertures d'alignement étant configurées pour s'engager avec des broches d'alignement correspondantes incluses sur le boîtier de compteur.

20. Compteur électrique selon l'une quelconque des revendications 1 à 19, dans lequel le premier connecteur électrique est monté sur une surface externe du module d'options de mesure, et le deuxième connecteur électrique est monté sur une surface externe du boîtier de compteur.

21. Compteur électrique selon la revendication 20, dans lequel une surface externe du boîtier de compteur est positionnée à proximité d'une surface externe du module d'options de mesure, de telle sorte que le premier connecteur électrique s'engage avec le deuxième connecteur électrique lorsque le module d'options de mesure est monté de manière amovible sur le boîtier de compteur.

22. Compteur électrique selon l'une quelconque des revendications 1 à 21, comprenant en outre un sceau de sécurité accouplé au boîtier de compteur et configuré pour indiquer quand le boîtier de compteur a été ouvert, dans lequel le module d'options de mesure peut être monté de manière amovible sur le boîtier de compteur sans affecter le sceau de sécurité.

23. Compteur électrique selon l'une quelconque des revendications 1 à 22, dans lequel une surface accessible depuis l'extérieur du boîtier de compteur comprend une première partie et une deuxième partie, la première partie étant conformée comme un emplacement pour recevoir le module d'options de mesure.

24. Compteur électrique selon la revendication 23, dans lequel le module d'options de mesure peut être positionné dans l'emplacement de manière à s'étendre vers l'extérieur sans dépasser environ le niveau de la dimension la plus externe d'une surface accessible depuis l'extérieur du boîtier de compteur.

25. Compteur électrique selon la revendication 23 ou 24, dans lequel la première partie est renfoncée par rapport à la deuxième partie, et une première surface plane du module d'options de mesure est essentiellement alignée de manière contiguë avec une surface plane de la première partie lorsque le module d'options de mesure est monté, et une deuxième surface plane du module d'options de mesure se trouve essentiellement dans le même plan qu'une surface plane de la deuxième partie du boîtier de compteur.

26. Compteur électrique selon l'une quelconque des revendications 23 à 25, comprenant en outre un couvercle amovible (181) conformé pour recouvrir une ouverture de l'emplacement.

27. Compteur électrique selon l'une quelconque des revendications 1 à 26, dans lequel le module d'option de mesure comprend une patte (124) configurée pour être accouplée au boîtier de compteur, dans lequel une cosse de terre comprise sur le boîtier de compteur est configurée pour mettre le module d'options de mesure à la terre et pour monter de façon fixe le module d'options de mesure sur le boîtier de compteur à l'aide de la patte.

28. Compteur électrique selon l'une quelconque des revendications 1 à 27, dans lequel le module d'options de mesure comprend une bride configurée pour être essentiellement contiguë au boîtier de compteur lorsque le module d'options de mesure est monté sur le boîtier de compteur, la bride étant en outre configurée pour être accouplée au boîtier de compteur avec une agrafe.

29. Compteur électrique selon l'une quelconque des revendications 1 à 28, dans lequel le deuxième connecteur électrique est utilisable pour alimenter le module d'options de mesure uniquement lorsque le module d'options de mesure est monté sur le boîtier de compteur.
